(19)

Europäisches
Patentamt
European
Patent Office
Office européen
des brevets

(11) **EP 4 575 438 A1**

(12) **EUROPEAN PATENT APPLICATION**
published in accordance with Art. 153(4) EPC

(43) Date of publication:
**25.06.2025 Bulletin 2025/26**

(21) Application number: **23937807.8**

(22) Date of filing: **19.05.2023**

(51) International Patent Classification (IPC):
***G01L 1/14*** (2006.01)  ***G06F 3/044*** (2006.01)

(52) Cooperative Patent Classification (CPC):
**G01L 1/14; G06F 3/044**

(86) International application number:
**PCT/CN2023/095165**

(87) International publication number:
**WO 2024/239126 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Shenzhen Shokz Co., Ltd.
Shenzhen, Guangdong 518108 (CN)**

(72) Inventors:
  • **YUAN, Yongshuai
    Shenzhen, Guangdong 518108 (CN)**

  • **DENG, Wenjun
    Shenzhen, Guangdong 518108 (CN)**
  • **HUANG, Yujia
    Shenzhen, Guangdong 518108 (CN)**
  • **ZHOU, Wenbing
    Shenzhen, Guangdong 518108 (CN)**
  • **LIAO, Fengyun
    Shenzhen, Guangdong 518108 (CN)**
  • **QI, Xin
    Shenzhen, Guangdong 518108 (CN)**

(74) Representative: **Wang, Bo
    Panovision IP
    Ebersberger Straße 3
    85570 Markt Schwaben (DE)**

(54) **SENSOR AND WEARABLE DEVICE**

(57)     Provided is a sensor and a wearable device. The sensor includes a sensing element (110). The sensing element (110) is applied to a housing (120). The housing (120) is configured to carry the sensing element (110). The sensing element (110) includes an electrode and a detecting end, each electrode corresponding to a detecting end. One end of the detecting end is connected with the electrode, and the other end of the detecting end is connected with a circuit of the sensor. The electrode connects an impedance of the body of a user into the sensor when the user is in contact with the electrode or the housing (120) in a region corresponding to the electrode.

**FIG. 1**

EP 4 575 438 A1

**Description**

**TECHNICAL FIELD**

The present disclosure relates to the technical field of sensor devices, and in particular, to sensors and wearable devices.

**BACKGROUND**

Touch operation is an important human-computer interaction method for wearable devices. Users can control wearable devices by inputting various control commands to sensors of the wearable devices through touch operations (e.g., swiping, clicking, double-clicking, longpressing, etc.). However, the sensors currently used (e.g., a capacitive sensing element and an inductive sensor) fail to function after being exposed to water, which is not conducive to application in scenarios that are easily contaminated with liquids (e.g., when swimming or in sports scenarios that are prone to sweating) when the sensors are applied to wearable devices.

Therefore, it is desirable to provide a sensor that may effectively avoid liquid interference.

**SUMMARY**

One of the embodiments of the present disclosure provides a sensor. The sensor may include a sensing element and a conductive structure. The sensor may be applied to a housing. The housing may be configured to carry the sensing element and the conductive structure, the sensing element may be disposed inside or on an inner sidewall of the housing, at least a portion of the conductive structure may be exposed to an external environment of the housing, and the conductive structure may be electrically connected with the sensing element.

Embodiments of the present disclosure also provide a wearable device. The wearable device may include a sensor. The sensor may include a sensing element, a conductive structure, and a wearable device body. One end of the conductive structure may be electrically connected with the sensing element. The wearable device body may include at least a carrier structure configured to carry the sensing element and the conductive structure. The sensing element may be disposed inside or on an inner sidewall of the carrier structure, at least a portion of the conductive structure may be exposed to an external environment of the carrier structure, and the conductive structure may be electrically connected with the sensing element.

One of the embodiments of the present disclosure further provides a sensor including a capacitive sensing element. The capacitive sensing element may be applied to a housing and disposed inside the housing. The capacitive sensing element may include a first electrode and a second electrode. The first electrode may be directly or indirectly connected with an inner surface of the housing and may have a first side, a side of the second electrode may be disposed opposite to the first side, and there may be a distance between the first electrode and the second electrode.

One of the embodiments of the present disclosure further provides a sensor including a sensing element. The sensing element may be applied to a housing, and the housing may be configured to carry the sensing element. The sensing element may include one or more electrodes and one or more detecting ends. Each electrode of the one or more electrodes may correspond to one detecting end of the one or more detecting ends, one end of the detecting end may be connected with the electrode, and another end of the detecting end may be connected with a circuit of the sensor. When a user is in contact with the electrode or a region of the housing corresponding to the electrode, the electrode and the detecting end may correspond to the electrode wire an impedance of the body of the user into the sensor.

Additional features may be set forth in part in the following description and may become apparent to those skilled in the art by reference to the following and the accompanying drawings or may be understood by the production or operation of examples. Features of the present disclosure may be realized and obtained by practicing or using aspects of the methods, tools, and combinations set forth in the following detailed examples.

**BRIEF DESCRIPTION OF THE DRAWINGS**

The present disclosure is further illustrated in terms of exemplary embodiments. These exemplary embodiments are described in detail with reference to the drawings. These embodiments are non-limiting exemplary embodiments, in which like reference numerals represent similar structures, and wherein:

FIG. 1 is a schematic diagram illustrating an exemplary sensor according to some embodiments of the present disclosure;
FIG. 2 is a schematic diagram illustrating another exemplary sensor according to some embodiments of the present disclosure;
FIG. 3 is a schematic diagram illustrating another exemplary sensor according to some embodiments of the present disclosure;
FIG. 4 is a schematic diagram illustrating a response waveform of an exemplary sensor according to some embodiments of the present disclosure;
FIG. 5 is a schematic diagram illustrating another exemplary sensor according to some embodiments of the present disclosure;
FIG. 6 is a schematic diagram illustrating another exemplary sensor according to some embodiments of the present disclosure;
FIG. 7 is a schematic diagram illustrating a response waveform of another exemplary sensor according to some embodiments of the present disclosure;

FIG. 8 is a schematic diagram illustrating a circuit structure of an exemplary sensor according to some embodiments of the present disclosure;

FIG. 9 is a schematic diagram illustrating a circuit structure of another exemplary sensor according to some embodiments of the present disclosure;

FIG. 10 is a schematic diagram illustrating a circuit structure of another exemplary sensor according to some embodiments of the present disclosure;

FIG. 11 is a schematic diagram illustrating an exemplary wearable device according to some embodiments of the present disclosure;

FIG. 12 is a schematic diagram illustrating another exemplary wearable device according to some embodiments of the present disclosure;

FIG. 13 is a schematic diagram illustrating another exemplary wearable device according to some embodiments of the present disclosure;

FIG. 14 is a schematic diagram illustrating another exemplary wearable device according to some embodiments of the present disclosure;

FIG. 15A is a schematic diagram illustrating an exemplary capacitive sensor according to some embodiments of the present disclosure;

FIG. 15B is a schematic diagram illustrating another exemplary capacitive sensor according to some embodiments of the present disclosure;

FIG. 16A is a schematic diagram illustrating another exemplary sensor according to some embodiments of the present disclosure;

FIG. 16B is a schematic diagram illustrating another exemplary sensor according to some embodiments of the present disclosure;

FIG. 16C is a schematic diagram illustrating another exemplary sensor according to some embodiments of the present disclosure;

FIG. 17 is a schematic diagram illustrating a body of a user in contact with a sensor according to some embodiments of the present disclosure;

FIG. 18 is a schematic diagram illustrating a droplet acting on a sensor according to some embodiments of the present disclosure;

FIG. 19 is a graph illustrating a change curve of a resonant frequency when a finger and a droplet act on electrodes of a sensor according to some embodiments of the present disclosure;

FIG. 20 is a schematic diagram illustrating an exemplary sensor according to some embodiments of the present disclosure;

FIG. 21 is a graph illustrating a change curve of an electrical signal in different touch manners according to some embodiments of the present disclosure;

FIG. 22 is a graph illustrating change curves of resonant frequencies collected when a finger and wet hair act on two needle electrodes of a sensor according to some embodiments of the present disclosure;

FIG. 23A is a graph illustrating change curves of resonant frequencies collected by a sensor according to some embodiments of the present disclosure;

FIG. 23B is a graph illustrating change curves of resonant frequencies collected by another sensor according to some embodiments of the present disclosure;

FIG. 23C is a graph illustrating change curves of resonant frequencies collected by another sensor according to some embodiments of the present disclosure;

FIG. 23D is a graph illustrating change curves of resonant frequencies collected by yet another sensor according to some embodiments of the present disclosure;

FIG. 24 is a diagram illustrating a signal of a sensor according to some embodiments of the present disclosure;

FIG. 25 is a graph illustrating a change curve of a resonant frequency collected by a sensor with a single electrode according to some embodiments of the present disclosure;

FIG. 26 is a graph illustrating a change curve of a resonant frequency collected by a sensor with a single electrode according to some embodiments of the present disclosure;

FIG. 27 is a graph illustrating change curves of resonant frequencies when a hand of a user acts on two electrodes in a sensor according to some embodiments of the present disclosure; and

FIG. 28 is a graph illustrating change curves of resonant frequencies when wet hair acts on two electrodes in a sensor according to some embodiments of the present disclosure.

## DETAILED DESCRIPTION

To more clearly illustrate the technical solutions related to the embodiments of the present disclosure, a brief introduction of the drawings referred to the description of the embodiments is provided below. Obviously, the drawings described below are only some examples or embodiments of the present disclosure. Those having ordinary skills in the art, without further creative efforts, may apply the present disclosure to other similar scenarios according to these drawings. Unless obviously obtained from the context or the context illustrates otherwise, the same numeral in the drawings refers to the same structure or operation.

As shown in the present disclosure and claims, the words "one," "a," "a kind," and/or "the" are not especially singular but may include the plural unless the context expressly suggests otherwise. In general, the terms "comprise," "comprises," "comprising," "include," "includes," and/or "including" merely prompt to include operations and elements that have been clearly identified, and these operations and elements do not constitute an exclusive listing. The methods or devices may also include other operations or elements.

In the description of the present disclosure, it is to be understood that the terms "front," "rear," "ear hook," "rear hook," etc. indicate orientation or positional relationships based on those shown in the accompanying drawings, and are used only for the convenience of describing the present disclosure and simplifying the description, and does not indicate or imply that the device or component referred to must have a specific orientation, be constructed and operated in a specific orientation, and therefore cannot be understood as a limitation of the present disclosure.

Additionally, the terms "first" and "second" are used for descriptive purposes only and are not to be construed as indicating or implying relative importance or implicitly specifying the number of technical features indicated. Therefore, a feature defined as "first" and "second" may expressly or impliedly include at least one of the features. In the description of the present disclosure, "plurality" means at least two, e.g., two, three, or the like, unless explicitly and specifically limited otherwise.

In the present disclosure, unless otherwise specified and limited, the terms "mounted," "connected," "connection," "fixed," etc. should be broadly understood, for example, it can be fixed connections, detachable connections, or integrated; it can be a mechanical connection or an electrical connection; it can be directly connected or indirectly connected through an intermediate medium, and can be a connection within two components or an interaction relationship between two components, unless otherwise specified. Those skilled in the art can understand the specific meanings of the above terms in the present disclosure according to the specific situation.

Embodiments of the present disclosure provide a sensor and a wearable device. The sensor penetrates a sidewall of the housing through a conductive structure, making one end of the conductive structure electrically connected with the sensor and the other end of the conductive structure extend to the outer surface of the housing. Thus, when a user performs a touch operation, the human body impedance may be connected to a measurement circuit of the sensor through the conductive structure to realize the touch operation. Since there is a large difference between the impedance value generated when the human body contacts the conductive structure of the sensor and the impedance value generated when a liquid such as water or sweat contacts the conductive structure of the sensor, the sensor provided by the embodiments of the present disclosure may exclude the influence of water, sweat, or other liquids on the touch operation, and improve the touch sensitivity of the sensor after being exposed to water. In some embodiments, the sensor may be applied to a wearable device, so that when a user manipulates the wearable device, the effect of liquids, such as water, sweat, etc. on the touch operation may be eliminated, and the touch sensitivity of the wearable device may be improved after being exposed to water. Exemplary wearable devices may include headphones, smart bracelets, smart rings, smart glasses, smart helmets, virtual reality devices, augmented reality devices, or the like.

The sensor and wearable device provided by the embodiments of the present disclosure are described in detail below in connection with the accompanying drawings.

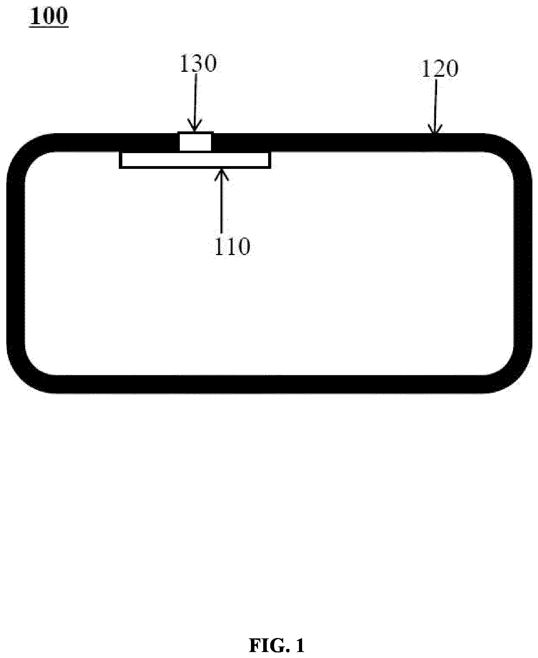

FIG. 1 is a schematic diagram illustrating an exemplary sensor according to some embodiments of the present disclosure.

Referring to FIG. 1, in some embodiments, the sensor 100 may include a sensing element 110 and a conductive structure 130. The sensing element 110 and the conductive structure 130 are applied to a housing 120, and the housing 120 is configured to carry the sensing element 110 and the conductive structure 130. In some embodiments, the sensing element 110 may be disposed inside or on an inner sidewall of the housing 120. The inner sidewall refers to a sidewall corresponding to an interior chamber of the housing 120. In some embodiments, at least a portion of the conductive structure 130 is exposed to the external environment of the housing 120 to be accessible to the skin of a user. In some embodiments, one end of the conductive structure 130 is electrically connected to a first electrode 1101, the other end of the conductive structure 130 may extend out of an inner surface of the housing 120, and the other end of the conductive structure 130 is concave downwardly with respect to an outer surface of the housing 120. When there are a plurality of conductive structures 130, two adjacent conductive structures 130 are separated by a housing region between the two adjacent conductive structures 130. The volume of a droplet is usually small, and when the droplet accumulates on the outer surface of the housing 120, the droplet typically accumulates at a single conductive structure 130, thereby preventing the droplet from connecting the two adjacent conductive structures 130. In some embodiments, the other end of the conductive structure 130 may extend out of the outer surface of the housing 120 such that a portion of the conductive structure 130 may be exposed to the external environment of the housing 120 for contact by the user. In some embodiments, the other end of the conductive structure 130 may also extend out of the housing 120 until it protrudes out of the outer surface. When the other end of the conductive structure 130 protrudes out with respect to the outer surface of the housing 120, the user may quickly determine the distribution position of the conductive structure 130 based on his/her sense of touch, to perform the relevant operation. When the user touches the conductive structure 130, the human body impedance of the user may be connected with the sensing element 110, and the sensing element 110 may generate a corresponding electrical signal in response to the touch operation of the user. For example, the sensing element 110 may generate a first signal in response to a sliding operation of the user. As another example, the sensing element 110 may generate a second signal in response to a click operation of the user. As yet another example, the sensing element 110 may generate a third signal in response to a double-click or multi-click operation of the user. In some embodiments, the sensing element 110 may include a capacitive sensing element and/or an inductive sensing element. In some embodiments, when the sensing element 110 is a capacitive sensing element, the capacitance value of the sensing element 110 may change in response to contact of the skin of the user (e.g., finger) with the conductive structure 130. Similarly, when the sensing element 110 is an inductive sensing element, the inductance value of the sensing element 110 may change in response to contact of the skin of the user (e.g., finger) with the conductive structure 130.

In some embodiments, the shape of the housing 120 may be a regular shape such as cylindrical, elliptical column, dome, prismatic (e.g., trigonal, rectangular, pentagonal), or other irregular three-dimensional shapes. In some embodiments, the material of the housing 120 may include plastic, resin, glass, metal, etc. In some embodiments, the housing 120 may be made of a transparent material. It should be noted that when the sensor 100 is applied to the wearable device, the housing 120 may be a structure that is independently disposed with respect to the wearable device, or it may be an integral structure with the wearable device, that is, the wearable device may serve as the housing of the sensor 100.

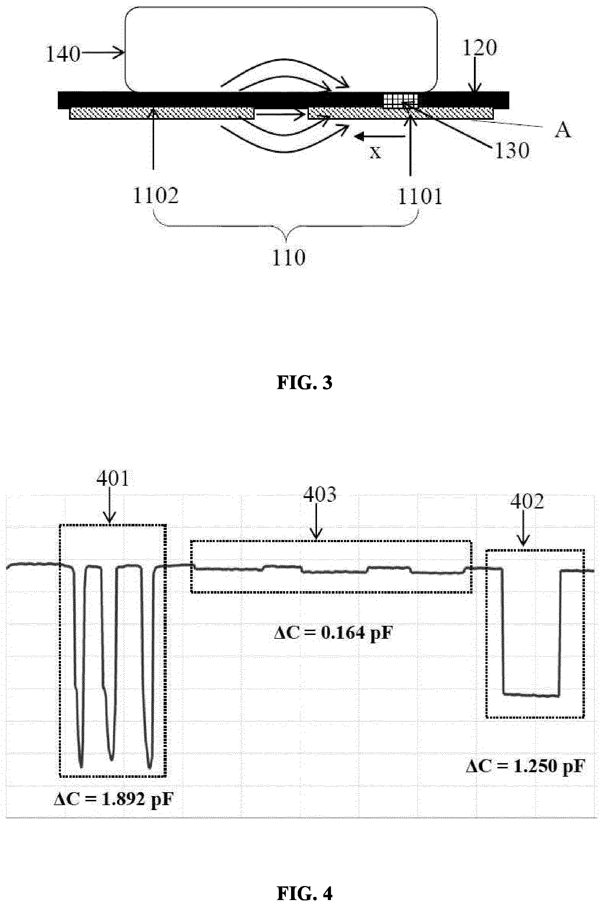

The conductive structure 130 may be an element made of a material that conducts electricity. In some embodiments, the material of the conductive structure 130 may include, but is not limited to, any one or more of silver, copper, gold, aluminum, nickel, alloys, carbon, etc. In some embodiments, the conductive structure 130 may be made of a transparent conductive material, such as an indium tin oxide film. In some embodiments, at least a portion of the conductive structure 130 is exposed to the external environment of the housing 120, and the conductive structure 130 may penetrate the sidewall of the housing 120 corresponding to the conductive structure 130 and be electrically connected with the sensing element 110 in the interior chamber or on the inner sidewall of the housing 120. When the user performs the touch operation, the user's finger may be in direct contact with the portion of the conductive structure 130 that is exposed to the external environment of the housing 120, thereby allowing the human body impedance to be connected with the measurement circuit of the sensor 100. In some embodiments, the conductive structure 130 may be an independently disposed element relative to the sensor element 110. For example, when the sensing element 110 is a capacitive sensing element, one end of the conductive structure 130 is electrically connected with an electrode plate of the capacitive sensing element. In some embodiments, the material of the conductive structure 130 may be the same as or different from the material of the sensing element 110. In some embodiments, the conductive structure 130 may be a portion of the sensor element 110. For example, when the sensing element 110 is a capacitive sensing element, the conductive structure 130 is integrally structured with an electrode plate of the capacitive sensing element, and the conductive structure 130 is a protruding structure on one side of the electrode plate. That is, a portion of an electrode plate of the capacitive sensing element may be exposed to the external environment of the housing 120. In some embodiments, one side of one electrode plate of the capacitive sensing element may all be exposed to the outside environment of the housing 120, and an other electrode plate of the capacitive sensing element may be located inside or on the inner sidewall of the housing 120. For example, one electrode plate of the capacitive sensing element is embedded in the sidewall of the housing 120, at which point the electrode plate may be considered as a portion of the sidewall of the housing 120, and, for ease of understanding, the conductive structure 130, as illustrated in FIG. 3, is replaced with a first electrode 1101.

It should be noted that since there is a large difference between the impedance value generated when the human body (e.g., the user's finger) contacts the conductive structure 130 and the impedance value generated when the droplet (e.g., a water droplet, sweat) contacts the conductive structure 130, the effect of liquids on the touch operation may be eliminated by the solution provided by the embodiments of the present disclosure, and a difference between a circuit output when the user contacts the conductive structure 130 and a circuit output when the user does not contact the conductive structure 130 may be increased, thereby increasing the touch sensitivity of the wearable device when exposed to water.

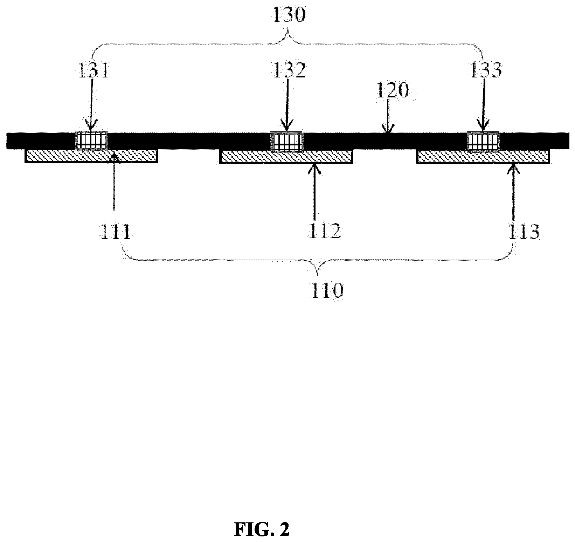

FIG. 2 is a schematic diagram illustrating another exemplary sensor according to some embodiments of the present disclosure. In some embodiments, the sensor 100 may include a plurality of sensing elements 110. Correspondingly, the sensor 100 may also include a plurality of conductive structures 130 having the same count as the sensing elements 110. The plurality of conductive structures 130 and the plurality of sensing elements 110 are in one-to-one correspondence. The housing 120 is provided with an aperture portion corresponding to each of the plurality of conductive structures 130. For each of the plurality of conductive structures 130, one end of the conductive structure 130 is electrically connected with a corresponding sensing element 110, and the other end of the conductive structure 130 extends to the outer surface of the housing 120 through its corresponding aperture portion. In such cases, the end of the conductive structure 130 away from the sensing element 110 is exposed to the external environment of the housing 120, so that the user's finger may be in direct contact with a portion of the conductive structure 130 exposed to the external environment of the housing 120 during the touch operation, thereby enabling the human body impedance to be connected to the circuit.

In some embodiments, the conductive structure 130 may be in interference contact with the inner wall of its corresponding aperture portion to ensure the sealing performance and the waterproof performance of the sensor 100. In some embodiments, in order to ensure the sealing performance and the waterproof performance of the sensor 100, the cross-sectional area of the end of the conductive structure 130 that extends to the outer surface of the housing 120 may be larger than the cross-sectional area of the aperture portion, such that the end of the conductive structure 130 that extends to the outer surface of the housing 120 covers the outer side of the aperture portion. In some embodiments, a waterproofing process may also be used to treat the connection between the conductive structure 130 and the aperture portion, for example, by filling the connection gap between the conductive structure 130 and the aperture portion with waterproofing adhesive, or the like.

In some embodiments, all the conductive structures 130 corresponding to the plurality of sensing elements 110 in the sensor 100 may extend into the external environment of the housing 120, such that the skin of the user may contact the conductive structures 130 exposed to the external environment. Referring to FIG. 2, in some embodiments, the sensor 100 may include a first sensing element 111 and a first conductive structure 131 corresponding to the first sensing element 111, a second sensing element 112 and a second conductive structure 132 corresponding to the second sensing element 112, and a third sensing element 113 and a third conductive structure 133 corresponding to the third sensing element 113. The housing 120 is provided with aperture portions corresponding to the first conductive structure 131, the second conductive structure 132, and the third conductive structure 133. One end of the first conductive structure 131, one end of the second conductive structure 132, and one end of the third conductive structure 133 are electrically connected with the first sensing element 111, the second sensing element 112, and the third sensing element 113, disposed inside or on the inner sidewall of the housing 120, respectively. The other ends of the first conductive structure 131, the second conductive structure 132, and the third conductive structure 133 extend to the outer surface of the housing 120 through the corresponding aperture portions.

It should be noted that the sensor 100 shown in FIG. 2 is illustrative only, and in some other embodiments, the count of the sensing element 110 and the count of the conductive structure 130 may be, but is not limited to, three. In some embodiments, the count of the sensing elements 110 and the count of the conductive structures 130 may also be 2, 4, 5, or more.

In some embodiments, the plurality of sensing elements 110 may be arranged in an array or a non-arrayed arrangement. In some embodiments, the plurality of sensing elements 110 may be arranged in a linear row. In some embodiments, the plurality of sensing elements 110 may be arranged in an array. In some embodiments, the plurality of sensing elements 110 may be arranged in an array of regular shapes such as triangles, circles, ovals, etc., or other irregular shapes. In some embodiments, the plurality of conductive structures 130 corresponding to the plurality of sensing elements may be spaced apart from each other. In some embodiments, the plurality of conductive structures 130 may be arranged in the same or a different shape as the plurality of sensing elements 110. In some embodiments, the plurality of sensing elements 110 are spaced apart when the sensor 100 includes the plurality of sensing elements 110. The sensor 100 may further include a processor, which may recognize a gesture of the user in response to time points of the user touching different sensing elements 110. For example, in some embodiments, the plurality of conductive structures 130 (or sensing elements 110) may be distributed in a straight line, and the user slides along an extension direction of the straight line. During the sliding process of the user's finger, the time points acting on different conductive structures 130 are different, and the time points at which the different sensing elements 110 generate electrical signals are different. The processor may determine the gesture (e.g., a direction of sliding) of the user based on the time points at which the different sensing elements 110 generate the electrical signals. In some embodiments, the gesture (e.g., a sliding direction) of the user may be applied to a work process of a wearable device (e.g., a smart helmet, a virtual reality device, an augmented reality device, smart glasses) or an electronic device (e.g., a headphone, a smartphone, a tablet, a smartwatch). For example, the processor controls one or more of the progress (e.g., fast-forward or fast-reverse) of audio or video, the volume level, the sliding of pages, or the like, of the wearable device or electronic device based on the gesture of the user. As another example, in some embodiments, a plurality of conductive structures 130 (or sensing elements 110) may be distributed in an array, and during the sliding process of the user's finger, the time points acting on different conductive structures 130 are different, and the time points at which the different sensing elements 110 generate electrical signals are different. The processor may determine the gesture of the user based on the time points at which the different sensing elements 110 generate the electrical signals. For example, the shape of the trajectory presented by the sliding gesture of the user may be any one or more of a letter (e.g., L, Z, M, V, O, C, U, I, S, N, etc.), an Arabic numeral, a geometrical shape (e.g., a circle, an ellipse, a polygon, etc.), or the like. In some embodiments, the gesture of the user may be applied to device status (e.g., unlocking or locking the screen), calling shortcut commands, etc., of the wearable device or the electronic device.

In some embodiments, the material of the conductive structure 130 may include, but is not limited to, any one or more of silver, copper, gold, aluminum, nickel, alloy, carbon, or the like. When there is a plurality of sensing elements 110 and conductive structures 130 in the sensor 100, a droplet may cover two adjacent conductive structures 130 at the same time if a distance between two adjacent conductive structures 130 is too small. That is, the two adjacent conductive structures 130 are connected by the droplet. When the user's finger acts on one of the two adjacent conductive structures 130 covered by the droplet, the other conductive structure 130 may also be indirectly connected with the user's finger through the droplet, thereby affecting the accuracy of the sensor 110 in recognizing the gesture of the user. In addition, since the size of the sensor 100 is small, if the distance between the two adjacent conductive structures 130 is too large, a small count of conductive structures 130 may be provided, which is not conducive to accurately obtaining a complex gesture of the user. Based on the above considerations, the distance between the two adjacent conductive structures in the plurality of conductive structures 130 may be within a range of 0.05 mm-5 cm. In some embodiments, the distance between the two adjacent conductive structures in the plurality of conductive structures 130 may be within a range of 0.08 mm-3 cm. In some embodiments, the distance between the two adjacent conductive structures in the plurality of conductive structures 130 may be within a range of 0.1 mm-1 cm. By adjusting the two adjacent conductive structures 130 to maintain an appropriate distance, the droplet may be prevented from simultaneously covering two adjacent conductive structures 130, thereby improving the accuracy of the sensor 110 in recognizing the gesture of the user. Moreover, the housing of the sensor 100 may be provided with a relatively large count of conductive structures 130, so that more gestures of the user may be acquired and the applicability of the sensor 100 may be improved. In some embodiments, two adjacent conductive structures 130 may have the same distance or different distances. In some embodiments, a droplet may be prevented from covering a plurality of (e.g., two or more) conductive structures 130 at the same time by controlling the distance between the two adjacent conductive structures 130. Merely by way of example, in some embodiments, it is found that the diameter of the sweat or water droplet deposited on the surface of the housing 120 is usually less than 5 mm. To avoid one droplet covering a plurality (e.g., two or more) of the conductive structures 130 at the same time, the distance between two adjacent conductive structures 130 may be within a range of 8 mm-1 cm. In some embodiments, to prevent liquid from accumulating at the conductive structure 130, a hydrophobic coating may be applied to the portion of the conductive structure 130 that extends to the outside environment of the housing 120 and/or to the outer surface of the housing 120, to reduce the adhesion force between the liquid and the structure of the conductive structure 130 extending into the outer surface of the housing 120 and/or the outer surface of the housing 120. Thus, the liquid slides off the outer surface of the housing 120 when the user sweats during exercise or touches water, which prevents the liquid from accumulating on the surface of the housing 120. In some embodiments, a protruding structure may be provided between two adjacent conductive structures 130 to form a curved surface on the housing 120 between the adjacent conductive structures 130 to prevent the liquid from accumulating at the conductive structures 130. In some embodiments, the portion of the conductive structure 130 that extends to the outer environment of the housing 120 may be concave downwardly with respect to the outer surface of the housing 120. In such cases, the two adjacent conductive structures 130 are separated by the housing region. The volume of the droplet is usually small. When the droplet accumulates on the outer surface of the housing 120, the droplet usually accumulates at a single conductive structure 130 due to the downward concavity of the conductive structure 130 with respect to the outer surface of the housing 120, thereby preventing the droplet from connecting the two adjacent conductive structures 130. In some embodiments, the conductivity of the conductive structure 130 may be greater than $10^6$ S/m to ensure that the conductive structure 130 has good conductivity, allowing the sensor to have a high response sensitivity when the user performs the touch operation and contacts the conductive structure 130.

In some embodiments, in order to facilitate the user to more clearly perceive the position of the conductive structure 130 when performing the touch operation, a damping structure may be provided at the end of the conductive structure 130 that extends out of the outer surface of the housing 120. The damping structure and the outer surface of the housing 120 may have different roughness. In some embodiments, the damping structure may include stripes, indentations, etc.

In some embodiments, only a portion of the conductive structures 130 of the plurality of conductive structures 130 of the sensor 100 may extend to the outer surface of the housing 120 and be exposed to the external environment of the housing 120, and the other conductive structures 130 may not extend to the outer surface of the housing 120. For example, the conductive structures 130 may be located in the interior chamber of the housing 120 or on the inner sidewall of the housing 120. For example, when the sensor 100 may include 5 conductive structures 130 and 5 sensing elements 110 corresponding to the 5 conductive structures 130, the count of conductive structures 130 that extend to the outer surface of the housing 120 may be within a range of 1-4. As another example, when the count of conductive structures 130 that extend to the outer surface of the housing 120 is two or more, the conductive structures 130 that extend to the outer surface of the housing 120 may be adjacent conductive structures arranged continuously in the plurality of conductive structures 130, or may be non-adjacent conductive structures at least partially spaced apart from one another in the plurality of conductive structures 130 of the sensor 100. In some embodiments, when the sensor 100 includes the plurality of conductive structures 130 and the plurality of sensing elements 110, and when the sensing elements 110 are the capacitive sensing elements, one of the plurality of conductive structures 130 may extend to the outer surface of the housing 120, and the other conductive structures 130 may be disposed in the interior chamber of the housing 120 or on the inner sidewall of the housing 120. When the sensor 100 includes the plurality of conductive structures 130 and only one conductive structure 130 extends to the outer surface of the housing 120, the droplet may be avoided from covering the plurality of conductive structures 130 at the same time.

In some embodiments, the conductive structure 130 in the sensor 100 that extends to the outer surface of the housing 120 may be provided on a side of the wearable device that is close to the skin of the user for detecting the wearable state. In some embodiments, the conductive structure 130 in the sensor 100 that extends to the outer surface of the housing 120 may be provided on the side of the wearable device that is away from the skin of the user, or other positions that allow for a touch operation in a wearing state for touch operation. A count of the conductive structure 130 in the sensor 100 that extends to the outer surface of the housing 120 may be one or more when applied to wearable detection. When applied to touch operation, the count of the conductive structure 130 in the sensor 100 that extends to the outer surface of the housing 120 may be one or more. Specifically, when the count of the conductive structure 130 (or the sensing elements 110) is one, the wearable device may be controlled by pressing (e.g., a long press) and tapping (e.g., a single click, a double click, etc.). When there are a plurality of conductive structures 130 (e.g., two or more), the user gesture may be recognized by the plurality of conductive structures 130 acting on different sensing elements 110 to control the wearable device. It should be noted that in the present disclosure, the side of the wearable device that is close to the skin of the user refers to a side of the wearable device that is close to the skin of the user in the wearing state. Similarly, the side of the wearable device that is away from the skin of the user refers to a side of the wearable device that is away from the skin of the user in the wearing state. In some embodiments, the wearable device includes a headphone, a smart watch, a smart bracelet, a smart ring, smart glasses, a smart helmet, a virtual reality device, an augmented reality device, or the like. For example, when the user performs a swipe-touch operation, the user's finger may sequentially contact at least two of the plurality of conductive structures 130, and the sensors may sequentially generate electrical signals in the order of contact. Further, the processor may determine the gesture of the user based on the position information of the contacted sensors and the time point at which the electrical signals are generated. In some embodiments, when applied to wearable detection, the conductive structures 130 may be provided on a contact region of the wearable device. The contact region refers to a region that may be in contact with the skin of the user when the wearable device is worn. When the wearable device is worn, a wearing part is in contact with the contact region, which may lead to deformation of the contact region, and the sensor generates a corresponding electrical signal. In some embodiments, the wearing state of the wearable device may be determined by combining the deformation of the contact region and the electrical signal generated by the sensor.

In some embodiments, the sensing element 110 may include a capacitive sensing element. Electrodes of the capacitive sensing element are electrically connected to an end of the conductive structure 130 disposed inside the housing 120, and the capacitance value may change in response to the finger or skin of the user contacting the conductive structure 130. In some embodiments, the conductive structure 130 and the electrodes of the capacitive sensing element to which it is connected may be two separate structures or a one-piece structure. For example, in some embodiments, the conductive structure 130 may be an element independently disposed with respect to the electrodes of the capacitive sensing element, and one end of the conductive structure 130 is electrically connected to an electrode plate of the capacitive sensing element. In some embodiments, the conductive structure 130 may be part of the electrodes of the capacitive sensing element. For example, the conductive structure 130 is integrally structured with an electrode plate of the capacitive sensing element, and the conductive structure 130 is a protruding structure on one side of the electrode plate. That is, a portion of an electrode plate of the capacitive sensing element may be exposed to the external environment of the housing 120. In some embodiments, one side of the electrode plate of the capacitive sensing element may be completely exposed to the external environment of the housing 120, and another electrode plate of the capacitive sensing element may be located inside or on the inner sidewall of the housing 120. For example, an electrode plate of the capacitive sensing element is embedded in a sidewall of the housing 120, at which point the electrode plate may be considered as a part of the sidewall of the housing 120. For ease of understanding, the conductive structure, such as the conductive structure 130 illustrated in FIG. 3, is replaced with the first electrode 1101.

FIG. 3 is a schematic diagram illustrating another exemplary sensor according to some embodiments of the present disclosure. Referring to FIG. 3, in some embodiments, the electrodes of the capacitive sensing element may include a first electrode 1101 and a second electrode 1102, with the first electrode 1101 and the second electrode 1102 disposed in the housing 120. In some embodiments, one side of the first electrode 1101 and one side of the second electrode 1102 may be connected to an inner surface of the same sidewall of the housing 120, and the first electrode 1101 and the second electrode 1102 are spaced apart along the inner surface of the same sidewall of the housing 120. The first electrode 1101 and the second electrode 1102 may be approximated as two electrode plates located in the same plane, and the first electrode 1101 and the second electrode 1102 have a distance between oppositely disposed ends, thereby constituting the capacitive sensing element. In some embodiments, the first electrode 1101 and the second electrode 1102 may not be connected to the inner surface of the housing 120. The first electrode 1101 and the second electrode 1102 are sheet-like structures, the first electrode 1101 has a first side A, and the first side A is a sidewall having the largest area among the sidewalls of the first electrode 1101. A side of the second electrode 1102 is provided side by side along an extension direction of the first side A (the direction indicated by the arrow x shown in FIG. 3), and one end portion of the first electrode 1101 is spaced apart from one end portion of the second electrode 1102. For example, the first electrode 1101 and the second electrode 1102 may be fixed in an interior chamber of the housing 120 by a fixing structure (e.g., a bracket, etc.). The extension direction of the first side A may be understood as the extension direction of a straight line passing through two points arbitrarily selected on the first side A. It will be understood that, in the present disclosure, the inner surface of the housing 120 refers to the inner wall of the cavity formed by the housing 120, and the outer surface of the housing 120 refers to a side of the housing 120 that is in direct contact with the outside space. As shown in FIG. 3, in some embodiments, the conductive structure 130 may be electrically connected to one of the first electrode 1101 or the second electrode 1102. When the user performs a touch operation, the finger 140 of the user may be in contact with the conductive structure 130, thereby allowing the human body impedance to be connected to the circuit.

FIG. 4 is a schematic diagram illustrating a response waveform of an exemplary sensor according to some embodiments of the present disclosure. As shown in FIG. 4, the waveform 401 is a response waveform generated by the sensor during the touch operation using a dry finger in some embodiments, wherein a capacitance change $\Delta C$ is about 1.892 pF. The waveform 402 is a response waveform generated when a concentrated saline droplet is used to cover two electrodes at the same time, wherein a capacitance change $\Delta C$ is about 1.250 pF. The waveband 403 is a response waveform generated by the sensor when the electrodes are covered with purified water, saline, and concentrated saline, wherein a capacitance change of $\Delta C$ is about 0.164 pF. According to FIG. 4, there is a significant difference between the response generated in the touch operation using the finger and the response generated when the electrodes are wetted with water (e.g., pure water, saline, or concentrated saline). However, when the droplet covers two or more electrodes at the same time, signal saturation may be generated, which may cause some interference with the recognition of the touch operation.

In some embodiments, to avoid or attenuate the oversized droplet leading to signal saturation, the liquid should be located on a single electrode (e.g., the first electrode 1101 or second electrode 1102) as much as possible. For example, the droplet may be avoided from covering a plurality of (e.g., two or more) electrodes simultaneously by optimizing an electrode size and a distance between two adjacent electrodes. For example, in some embodiments, the size (e.g., length) of a single electrode may be within a range of 2 mm-5 mm, and the distance between two adjacent electrodes may be within a range of 8 mm-10 mm. In some embodiments, a hydrophobic coating may be applied to the outer surface of the housing 120 to reduce the adhesion force between the liquid and the end of the conductive structure 130 protruding out of the outer surface of the housing 120 and/or the outer surface of the housing 120. Thus, when the user sweats during exercise or touches water, the liquid may slide off the surface of the housing 120 to avoid accumulation of liquid on the surface of the housing 120. In some embodiments, considering that the liquid is usually sliding downward by gravity during sliding off the surface of the housing 120, to avoid the liquid from covering two or more electrodes at the same time during the sliding process, the plurality of electrodes may be arranged in a direction different from the sliding direction of the liquid in the wearing state. For example, when a user wears a wearable device (e.g., a headphone) including the sensor 100, the droplet of the liquid slides downwards along a direction that is approximately perpendicular to the ground under the influence of gravity. Taking a single sensor 100 as an example, the two electrodes of the sensor 100 may be spaced apart in a direction that is parallel to the ground. In some embodiments, a protruding structure may be provided on the housing 120 between two adjacent electrodes to block the flow of the droplet. Merely by way of example, droplets are free to flow in a flat plane, and providing the protruding structure on the housing 120 between two adjacent electrodes or setting the portion of the housing to a curved surface structure protruding toward the outside of the housing, the droplets at a single electrode may be blocked from flowing toward the other electrode, thereby effectively avoiding the droplets from covering two electrodes of a single sensor at the same time. In some embodiments, a shield may be provided between electrodes and voltage may be applied to the shield such that when the sensor scans other buttons, the voltage of the shield is consistent with the voltage of the electrodes, which may minimize the effect of droplets on the electrodes.

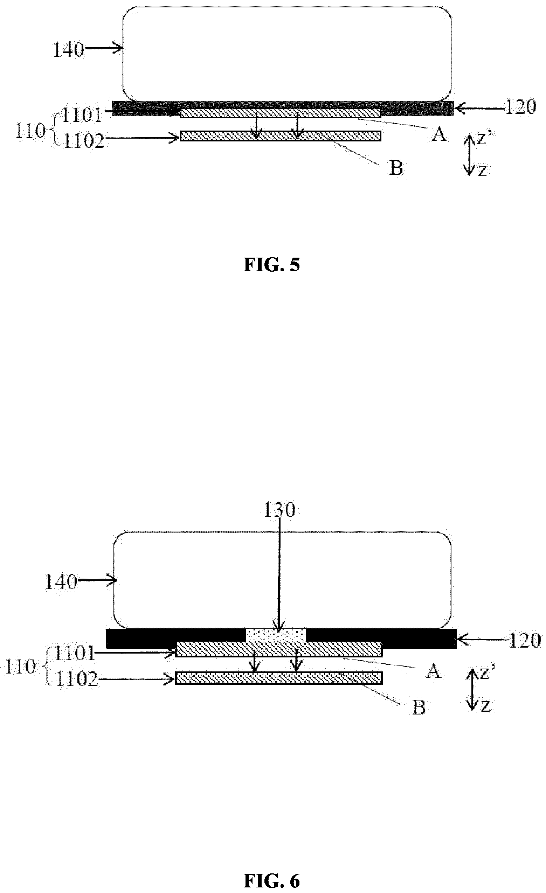

FIG. 5 is a schematic diagram illustrating another exemplary sensor according to some embodiments of the present disclosure.

Referring to FIG. 5, in some embodiments, the electrodes of the capacitive sensing element may include a first electrode 1101 and a second electrode 1102. The first electrode 1101 and the second electrode 1102 are disposed in the interior of the housing 120. A first side A of the first electrode 1101 faces a side (e.g., a side B) of the second electrode 1102. That is, a projection of the first electrode 1101 in a direction perpendicular to the first side A of the first electrode 1101 overlaps at least partially with the second electrode 1102. In some embodiments, there is a distance between the first electrode 1101 and the second electrode 1102, and the first electrode 1101 and the second electrode 1102 may form a capacitive sensing element. It should be noted that the first electrode 1101 and the second electrode 1102 have sheet-like structures, and the first side A is a sidewall with the largest area among the sidewalls of the first electrode 1101. Similarly, the side of the second electrode 1102 is a sidewall with the largest area among the sidewalls of the second electrode 1102.

As shown in FIG. 5, in some embodiments, the first electrode 1101 may be connected to the inner surface of the housing 120, and the second electrode 1102 may be disposed in an interior chamber of the housing 120. The second electrode 1102 is disposed parallel or approximately parallel relative to the first electrode 1101, and there is a distance between the two to constitute the capacitive sensing element. When the user performs a touch operation, the finger 140 of the user is not in direct contact with the first electrode 1101 and the second electrode 1102, but can change the capacitance value of the capacitive sensing element constituted by the first electrode 1101 and the second electrode 1102. It is noted that the first electrode 1101 may also not be connected to the inner surface of the housing 120. For example, the first electrode 1101 or the second electrode 1102 may be provided in an interior chamber of the housing 120 by a fixed structure (e.g., a bracket).

Referring to FIG. 5, in some embodiments, the first electrode 1101 may be attached to an inner surface of the housing 120 or at least partially embedded in an inner wall of the housing 120. In some embodiments, a thickness of the housing 120 in a region corresponding to the first electrode 1101 may be not greater than 1 mm. Specifically, the thickness of the sidewall of the housing 120 in the region corresponding to the first electrode 1101 in a direction perpendicular to the first electrode 1101 (e.g., the z-z' direction shown in FIG. 5) is not greater than 1 mm, thereby ensuring the sensitivity of the sensor without exposing the electrode. In some embodiments, by embedding at least a portion of the first electrode 1101 in the inner wall of the housing 120, the first electrode 1101 may not take up too much space, making the sensor as small as possible. If the thickness of the sidewall of the housing 120 in the region corresponding to the first electrode 1101 is too small, the stability of the sidewall of the housing 120 may be affected and the sidewall may be prone to damage. To ensure that the sensor has a high sensitivity without exposing the electrode and to ensure the stability of the sidewall of the housing 120, in some embodiments, the thickness of the sidewall of the housing 120 in the region corresponding to the first electrode 1101 may be within a range of 0.2 mm-1 mm.

FIG. 6 is a schematic diagram illustrating another exemplary sensor according to some embodiments of the present disclosure. Referring to FIG. 6, in some embodiments, the electrodes of the capacitive sensing element may include a first electrode 1101 and a second electrode 1102. The first electrode 1101 and the second electrode 1102 are located inside the housing 120. A first side A of the first electrode 1101 faces a side (e.g., a side B) of the second electrode 1102. That is, a projection of the first electrode 1101 in a direction perpendicular to the first side A of the first electrode 1101 overlaps at least partially with the second electrode 1102. As shown in FIG. 6, there is a distance between the first electrode 1101 and the second electrode 1102, and the first electrode 1101 and the second electrode 1102 may form a capacitive sensing element. In some embodiments, one side of the first electrode 1101 may be directly connected with an inner surface of the housing 120 or embedded in a sidewall of the housing 120. In some embodiments, the first electrode 1101 and the second electrode 1102 may not be connected to the inner surface of the housing 120. For example, the first electrode 1101 and the second electrode 1102 may be fixed in an interior chamber of the housing by a fixing structure (e.g., a bracket, etc.). In some embodiments, the distance between the first electrode 1101 and the second electrode 1102 may be within a range of 8 mm-10 mm. In some embodiments, one end of the conductive structure 130 is electrically connected to the first electrode 1101, the other end of the conductive structure 130 may extend out of the inner surface of the housing 120, and the other end of the conductive structure 130 is concave downwardly with respect to the outer surface of the housing 120. When there are a plurality conductive structures 130, two adjacent conductive structures 130 are separated by a housing region between the two adjacent conductive structures 130. The volume of a droplet is usually small, and when the droplet accumulates on the outer surface of the housing 120, since the conductive structures 130 are concave downwardly relative to the outer surface of the housing 120, the droplet accumulates at a single conductive structure 130, thereby preventing the droplet from connecting the two adjacent conductive structures 130. In some embodiments, the other end of the conductive structure 130 may protrude out of the outer surface of the housing 120 such that a portion of the conductive structure 130 may be exposed to the external environment of the housing 120 for user contact. Further, the other end of the conductive structure 130 may extend out of the housing 120 until it protrudes out of the outer surface. When the other end of the conductive structure 130 protrudes with respect to the outer surface of the housing 120, the user may quickly determine the distribution position of the conductive structure 130 based on the sense of touch, to perform the relevant operation.

In some embodiments, the sensor 100 may further include a processor that may determine whether the user is contacting the sensor based on a capacitance change value of the capacitive sensing element. Specifically, in some embodiments, the processor determining whether the user is contacting the sensor based on the capacitance change value of the capacitive sensing element may include: when the capacitance change value of the capacitive sensing element is greater than a predetermined threshold, determining that the user is contacting the sensor, or when the capacitance change value of the capacitive sensing element is less than the preset threshold, determining that the user is not contacting the sensor.

It should be noted that the count of the sensing element 110, the count of the conductive structure 130, and the count of other elements in the sensor shown in FIG. 3 to FIG. 6 are not limited to one shown in the drawings but may be multiple. More description regarding the distribution of the plurality of sensing elements 110 or the conductive structures 130 may be found in FIG. 2 of the present disclosure and its related descriptions and will not be repeated herein.

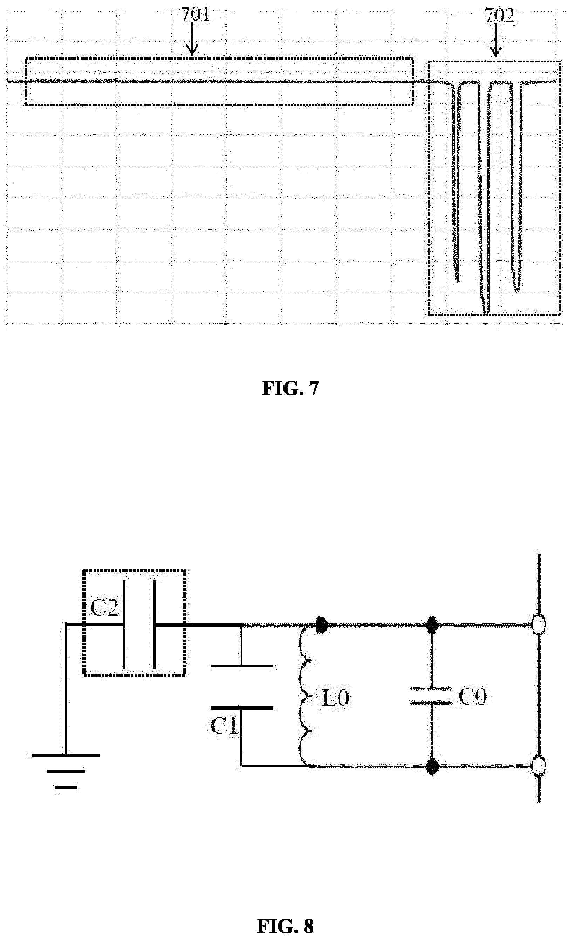

FIG. 7 is a schematic diagram illustrating a response waveform of another exemplary sensor according to some embodiments of the present disclosure. Referring to FIG. 7, in some embodiments, when pure water, saline, or concentrated saline is used to act on the sensors illustrated in FIG. 5 or FIG. 6, the response waveform is shown as waveform 701. When a dry finger or a watery finger is used to act on the sensor shown in FIG. 5 or FIG. 6, the response waveform is shown as waveform 702. As can be seen, using the sensor shown in FIG. 5 or FIG. 6, the touch operation response of the finger of the user may be greatly different from the response generated when the sensor is wet but not touched by the finger, which may eliminate the influence of liquid such as water or sweat on the touch operation, thereby improving the touch sensitivity of the sensor.

In some embodiments, when the sensing element is a capacitive sensing element, the capacitive sensing element may be connected with a measurement circuit to obtain a capacitance change value of the capacitive sensing element. The measurement circuit obtaining the capacitance change value of the capacitive sensing element is described in detail in the following in conjunction with FIGs. 8 to FIG. 10.

FIG. 8 is a schematic diagram illustrating a circuit structure of an exemplary sensor according to some embodiments of the present disclosure.

Referring to FIG. 8, in some embodiments, a capacitive element C1 and a capacitive element C2 may be included in the circuit structure of the sensor. C1 denotes a capacitor formed by the first electrode 1101 and the second electrode 1102 as shown in FIG. 3, FIG. 5, or FIG. 6, and the capacitive element C2 denotes the equivalent capacitor corresponding to the human body impedance when it is connected to the circuit.

Since the human body has a specific capacitive property that liquids do not have, by electrically connecting the conductive structure 130 extending to the outer surface of the housing 120 with the electrodes of the capacitive sensing element, the finger 140 of the user may both change the capacitance value of the capacitive element C1 and introduce the capacitive element C2 into the circuit (i.e., to introduce the human body impedance) when the finger 140 of the user performs the touch operation. On the contrary, when only the liquid is in contact with the conductive structure 130, the capacitive element C2 in the circuit is considered to be absent, and only the capacitance value of the capacitive element C1 may be changed. In such cases, in some embodiments of the present disclosure, by electrically connecting the conductive structure 130 extending to the outer surface of the housing 120 to the electrodes of the capacitive sensing element, the difference between the capacitance value generated when the finger of the user contacts the conductive structure 130 and the capacitance value generated when the water, sweat, or other liquids contacts the conductive structure 130 may be increased, which eliminates the influence of water, sweat, or other liquids on the touch operation and increases the touch sensitivity of the sensor after being wetted with water.

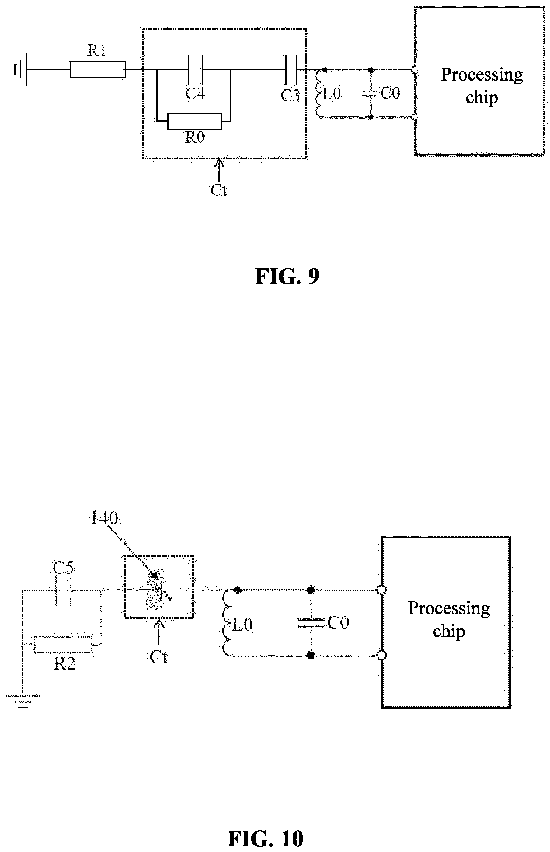

FIG. 9 is a schematic diagram illustrating a circuit structure of another exemplary sensor according to some embodiments of the present disclosure. Referring to FIG. 9, in some embodiments, the measurement circuit of the sensor may include a resistive element R0, a resistive element R1, a capacitive element C3, and a capacitive element C4. The capacitive element C3 denotes the capacitive sensing element formed by the first electrode 1101 and the second electrode 1102 as shown in FIG. 3, FIG. 5, or FIG. 6. The capacitive element C4 denotes the equivalent capacitive element corresponding to the human body impedance when the human body impedance is connected to the circuit. The resistive element R0 denotes the equivalent resistance corresponding to the human body impedance when the human body impedance is connected to the circuit. As shown in FIG. 9, the resistive element R0 may be connected in parallel with the capacitive element C4, and the resistive element R1 and the capacitive element C3 may be connected in series with the capacitive element C4, thereby forming an RC circuit. In some embodiments, the resistive element R0, the capacitive element C4, and the capacitive element C3 may form a capacitor Ct, which may reflect the overall capacitance change in the circuit after the human body impedance is connected to the circuit. In some embodiments, the RC circuit may be used to obtain the capacitance value of the capacitor Ct.

Continuing with reference to FIG. 9, the measurement circuit of the sensor may further include an inductive element, a capacitive element, and a processing chip. The inductive element and the capacitive element are connected in parallel to form a loop, and the processing chip may be configured to read a resonant frequency of the loop formed by the inductive element and the capacitive element. In some embodiments, the capacitance value of the capacitor Ct may be characterized by the resonant frequency of the loop formed by the inductive element and the capacitive element in the parallel connection.

In some embodiments, the loop formed by the inductive element and the capacitive element may be equivalent to a resonance circuit, which may face the position of the capacitive sensing element to obtain the resonant frequency of the capacitive sensing element. Referring to FIG. 9, in some embodiments, the resonance circuit may include a first inductive element L0, a first capacitive element C0, and a first processing chip. The first inductive element L0 is connected with the first capacitive element C0 in parallel to form a loop, and the first processing chip is configured to read out a resonant frequency of the loop.

FIG. 10 is a schematic diagram illustrating a circuit structure of another exemplary sensor according to some embodiments of the present disclosure.

Referring to FIG. 10, in some embodiments, the measurement circuit of the sensor may include a resistive element R2 and a capacitive element C5. The resistive element R2 is connected in parallel with the capacitive element C5 to form an RC loop. When the finger 140 of the user contacts the sensor, the capacitance value of the capacitor Ct may be changed. It can be understood that the capacitor Ct may be understood as the equivalent capacitor formed by the human body impedance when it is connected to the circuit together with a built-in capacitive sensing element in the sensor. More descriptions regarding the capacitor Ct may be found elsewhere in the present disclosure and may not be repeated here. In some embodiments, the RC loop formed by the resistive element R2 and the capacitive element C5 in parallel may be configured to obtain the capacitance value of the capacitor Ct.

In some embodiments, the sensing element 110 may include an inductive sensing element, which may include an inductive element, a capacitive element, and a processing chip. The inductive element is electrically connected with one end of the conductive structure 130 disposed inside of the housing 120, and the inductive element is connected in parallel with the capacitive element to form a loop. The processing chip may be connected to the loop formed by the inductive element and the capacitive element to read a resonant frequency of the loop. In some embodiments, the processing chip may recognize a touch operation of the user based on the resonant frequency of the loop.

In some embodiments, the count of the inductive elements may be one or more (e.g., two or more). Similarly, the sensor 100 may also include a plurality of conductive structures 130 having the same count as the inductive elements, and the plurality of conductive structures 130 and the plurality of inductive elements are in one-to-one correspondence. When the sensing element 110 is an inductive sensing element, the sensor 100 may also be configured for wear detection or touch operation detection. In some embodiments, when the inductive sensing element is applied for wearable detection, the count of the inductive sensing elements may be only one. In some embodiments, when the inductive sensing element is applied to touch operation detection, the count of the inductive sensing elements may be one or more. For example, when the touch operation is a slide control, the count of the inductive sensing elements may be at least two. As another example, when the touch control operation is a single click, a double click, etc., the count of the inductive sensing elements may be only one.

Embodiments of the present disclosure also provide a wearable device that may include a wearable device body and a sensor as provided in any of the above embodiments. The wearable device body refers to the remaining body portion without the sensor. In some embodiments, the wearable device body may include at least a carrier structure, which may be configured to carry the sensing element of the sensor. Specifically, in some embodiments, the sensing element may be disposed in an interior chamber or on an inner sidewall of the carrier structure, and one end of the conductive structure away from the sensing element may extend to an outer surface of the carrier structure. In some embodiments, the carrier structure may be understood as a structure or part that has a certain degree of rigidity and is used to mount the sensor. In some embodiments, the carrier structure may refer to the housing of the wearable device. Descriptions regarding the position of the conductive structure relative to the carrier structure may be found in the descriptions regarding the conductive structure relative to the housing, which will not be repeated here.

It should be noted that, in some embodiments, by electrically connecting the conductive structure extending to the outer surface of the carrier structure to the sensing element, the user can directly contact the conductive structure with the finger when performing a touch operation, such that the human body impedance may be connected to the electric circuit, which increases the difference between the capacitance value generated when the user's finger is in contact with the conductive structure and the capacitance value generated when the water, sweat, or other liquids is in contact with the conductive structure, thereby eliminating the effect of water, sweat, or other liquids on the touch operation, thus improving the touch sensitivity of the wearable device wetted with water. More details regarding the sensor may be found elsewhere in the present disclosure (e.g., FIGs. 1-10, and their related descriptions) and will not be repeated here.

In some embodiments of the present disclosure, the wearable device may include a headphone, a smart bracelet, a smart ring, smart glasses, a smart helmet, a virtual reality device, an augmented reality device, or the like. It should be understood that the above wearable device is only an exemplary illustration, and in embodiments of the present disclosure, the wearable device may include, but is not limited to, the foregoing devices.

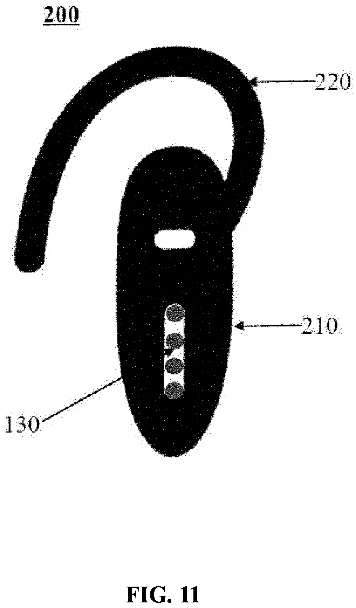

FIG. 11 is a schematic diagram illustrating an exemplary wearable device according to some embodiments of the present disclosure.

Referring to FIG. 11, in some embodiments, the wearable device may be an acoustic output device 200, and the wearable device body may include an acoustic output unit 210 and an ear hook 220. One end of the ear hook 220 is connected to the acoustic output unit 210, and the user may hang the acoustic output unit 210 near the user's ear via the ear hook 220 when using the acoustic output device 200.

As shown in FIG. 11, in some embodiments, the acoustic output device 200 may include a single-ear hanging earphone, which may be a bone-conducting earphone, an air-conducting earphone, or a bone-air-conducting combined earphone. In some embodiments, the acoustic output device 200 may include various types, such as an electromagnetic type (e.g., moving coil type, moving iron type, etc.), a piezoelectric type, an inverse piezoelectric type, an electrostatic type, or the like. In some embodiments, the conductive structure 130 may be provided on the acoustic output unit 210 and/or the ear hook 220. In some embodiments, the conductive structure 130 may be provided on any one or more of the inner, outer, and circumferential sides of the housing of the acoustic output unit 210. The inner side refers to a side that is close to the skin of the user when the acoustic output device 200 is worn by the user, the outer side refers to a side that is away from the skin of the user when the acoustic output device 200 is worn by the user, and the circumferential side refers to the side that is adjacent to either the inner or outer side of the acoustic output unit 210. In some embodiments, when the user wears the acoustic output device 200, the conductive structure 130 provided at the outer side or the circumferential side of the housing of the acoustic output unit 210 that is not in contact with the skin of the user may be used for touch operation. In some embodiments, the conductive structure 130 may be provided on the outer side of the housing of the acoustic output unit 210 so that the user's hand can act on the sensor. Furthermore, when the acoustic output device 200 is in the wearing state, the inclination angle of a side surface corresponding to the outer side of the housing of the acoustic output unit 210 relative to the sagittal plane of the human body is extremely small or approximately regarded as parallel, and the droplets at the outer side of the acoustic output unit 210 slide down directly under the effect of gravity and do not accumulate, thereby reducing the interference of the droplets on the sensor. In some embodiments, the touch operation may include, but is not limited to, clicking, double-clicking, swiping, long pressing, or the like. In some embodiments, the wearable device may be controlled to perform operations such as waking up the device, answering the phone call, playing the music, adjusting the volume, hanging up the phone call, pausing the music, music switching, audio adjustment, unlocking or locking the device, etc., by the touch operation. For example, when the count of the sensors is one, the user may click on the conductive structure 130 of the sensor to adjust the audio volume output by the acoustic output unit. As another example, when the user long presses on the conductive structure of the sensor, the progress of the audio output from the acoustic output unit may be changed (pause, on, fast-forward, or rewind) or the audio output from the acoustic output unit may be changed. As a further example, when the count of the sensors is more than one, the user, when sliding along the distribution direction of the conductive structure 130, may adjust the audio volume or the audio progress of the output of the acoustic output unit. In some embodiments, the sensor may also be configured to detect the wearing state of the acoustic output unit 200. In some embodiments, when the user is wearing the acoustic output device 200, the conductive structure 130 may be provided on the housing of the acoustic output unit 210 or the ear hook 220 in a region in contact with the skin of the user to perform the wear detection. Specifically, when the acoustic output device 200 is not worn, the conductive structure 130 is not in contact with the human skin, and the sensor does not generate an electrical signal. However, when the user wears the acoustic output device 200, the conductive structure 130 is in contact with the human skin, the sensor generates a corresponding electrical signal, and the processor of the acoustic output device 200 may determine that the acoustic output device 200 is in a wearing state based on the electrical signal, thereby activating or unlocking the acoustic output device 200. When the conductive structure 130 is provided on the ear hook 220, the ear hook includes a memory alloy (e.g., titanium alloy) strip structure and an adhesive sleeve encasing the strip structure, electrodes corresponding to the conductive structure 130 may be connected to the memory alloy strip structure by adhesive bonding or plating, and at least a portion of the conductive structure 130 may protrude out of the adhesive sleeve to be exposed to the external environment. In some embodiments, at least a portion of the electrodes may be exposed to the external environment when the sensing element is not provided with the conductive structure 130.

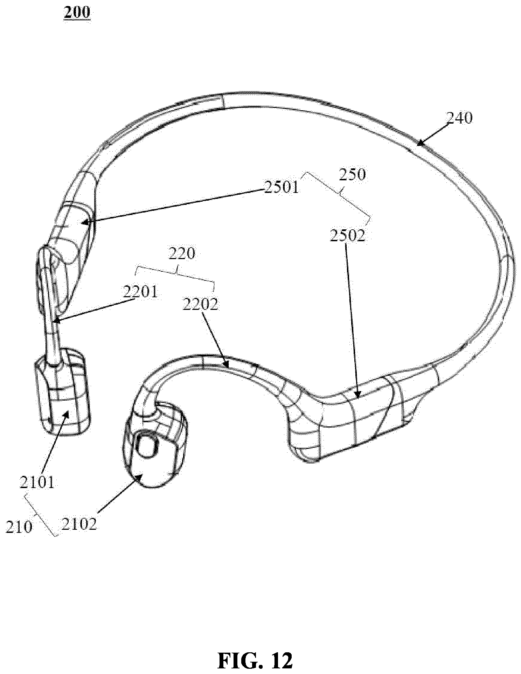

FIG. 12 is a schematic diagram illustrating another exemplary wearable device according to some embodiments of the present disclosure.

Referring to FIG. 12, in some embodiments, the acoustic output device 200 may also include a rear hook 240, in other words, the acoustic output device 200 may also be a rear-hook earphone, which may include an ear hook 220, a rear hook 240, and an acoustic output unit 210. The ear hook 220 may cooperate with the ear contour of the user, so that the acoustic output device 200 may be hung on the ear of the user. The rear hook 240 may be placed behind the user's neck or head. The ear hook 220 and the rear hook 240 may cooperate to provide a clamping force for wearing the acoustic output unit 210 on the user's head or ear so that the acoustic output device 200 may be stably hung on the user's ear and not easily fall off.

As shown in FIG. 12, in some embodiments, the acoustic output unit 210 may include a first acoustic output unit 2101 and a second acoustic output unit 2102. The ear hook 220 may include a first ear hook 2201 and a second ear hook 2202. The first ear hook 2201 is connected to the first acoustic output unit 2101 and one end of the rear hook 240, and the second ear hook 2202 is connected to the second acoustic output unit 2102 and the other end of the rear hook 240. The first ear hook 2201 may be configured to hang the first acoustic output unit 2101 near one ear of the user, and the second ear hook 2202 may be configured to hang the second acoustic output unit 2102 near the other ear of the user.

Referring to FIG. 12, in some embodiments, the wearable device body may further include a core assembly 250, which may be disposed between the ear hook 220 and the rear hook 240. In some embodiments, the core assembly 250 may include an accommodating cavity that may be configured to hold or accommodate one or more components (e.g., a processor, a control circuit, a Bluetooth module, a battery, etc.) of the acoustic output device 200. In some embodiments, the core assembly 250 may include a first core assembly 2501 and a second core assembly 2502. The first core assembly 2501 is connected to the first ear hook 2201 and one end of the rear hook 240, and the second core assembly 2502 is connected to the second ear hook 2202 and the other end of the rear hook 240.

In some embodiments, the conductive structure 130 may be disposed on an inner, outer, or circumferential side of the core assembly 250. Specifically, when the conductive structure 130 is provided on the inner side of the core assembly 250, wear detection may be performed through the conductive structure 130. When the conductive structure 130 is provided on the outer or the circumferential side of the core assembly 250, touch operation may be performed through the conductive structure 130. Similarly, in some embodiments, the conductive structure 130 may be provided on the inner, outer, or circumferential side of the acoustic output unit 210. Specifically, when the conductive structure 130 is provided on the inner side of the acoustic output unit 210 that is in contact with human skin, wear detection may be performed through the conductive structure 130. When the conductive structure 130 is provided on the outer or circumferential side of the acoustic output unit 210 that is not in contact with human skin, touch operation may be performed through the conductive structure 130. More descriptions regarding the conductive structure 130 may be found elsewhere in the present disclosure, and will not be repeated here.

In some embodiments, the wearable device may further include a second inductive sensing element (not shown in the figure), which may have the same structure as the first inductive sensing element. In some embodiments, the second inductive sensing element may be disposed on the ear hook 220 or the rear hook 240, and the second inductive sensing element may determine the deformation amount of the ear hook 220 or the rear hook 240 based on the deformation of the ear hook 220 or the rear hook 240. For example, in some embodiments, the deformation amount of the ear hook 220 or the rear hook 240 may be determined based on the inductance change of the second inductive sensing element caused by the deformation of the ear hook 220 or the rear hook 240. In some embodiments, the processor of the wearable device may determine the wearing state of the wearable device based on the deformation amount of the ear hook 220 or the rear hook 240 detected by the second inductive sensing element.

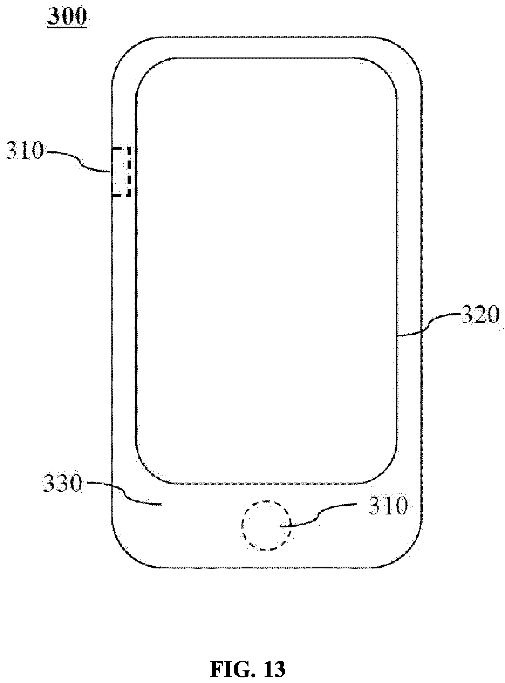

FIG. 13 is a schematic diagram illustrating another exemplary wearable device according to some embodiments of the present disclosure. Referring to FIG. 13, in some embodiments, the wearable device may be a cell phone or a tablet, and the cell phone or tablet computer 300 may include a display 320 and a body 330, with the display 320 embedded in the body 330. The sensor may be provided in a touch region 310 of the cell phone or tablet 300. The touch region 310 may be understood as an operation region where the user performs the touch operation. In some embodiments, the touch region 310 may be located on a side of the body 330 that is coplanar with the display 320. In some embodiments, the touch region 310 may be disposed on a side of the body 330 that is adjacent or opposite to the plane on which the display 320 is located. In some embodiments, the touch region 310 may also be integrated into the display 320. The user may control the cell phone or tablet 300 by acting on the touch region 310 by tapping, long pressing, or swiping.

In some embodiments, the user acts on the touch region 310 to wake up the cell phone or tablet 300 or put it into a standby mode. In some embodiments, the user may long press on the touch region 310 to turn the cell phone or tablet 300 on or off. In some embodiments, the user may act on the touch region 310 to adjust the volume of the cell phone or tablet 300. In some embodiments, the user may act on the touch region 310 to start a voice call or a video call on the cell phone or tablet 300. In some embodiments, the user may act on the touch region 310 to adjust the progress of the video or audio. In some embodiments, one or more sensors may be provided at the touch region 310. For example, in some embodiments, the touch region 310 may include a first sensor and a second sensor, and the user acts on the first sensor by tapping or pressing, etc., to advance the progress of the video or audio. The user acts on the second sensor by tapping or pressing, etc. to rewind the progress of the video or audio.

In some embodiments, a control gesture of the user may be recognized through a plurality of sensors provided in the touch region 310. In some embodiments, the plurality of sensors may be distributed in the form of a rectangle, triangle, or any combination thereof, and the user swipes through at least two sensors in the touch region 310 to realize different functional controls of the cell phone or tablet 300. In some embodiments, the user may control the progress of the video or audio by controlling the direction of the swipe of the gesture. In some embodiments, the user may slide a corresponding pattern within the touch region 310 to compare with a preset pattern to unlock the cell phone or tablet 300. In some embodiments, the user may slide downward within the touch region 310 to realize a downward page turn of the cell phone or tablet 300, and the user may also slide upward within the touch region 310 to realize an upward page turn of the cell phone or tablet 300. In some embodiments, the user may slide a "Z" shape within the touch region 310 to take a screenshot of the cell phone or tablet 300.

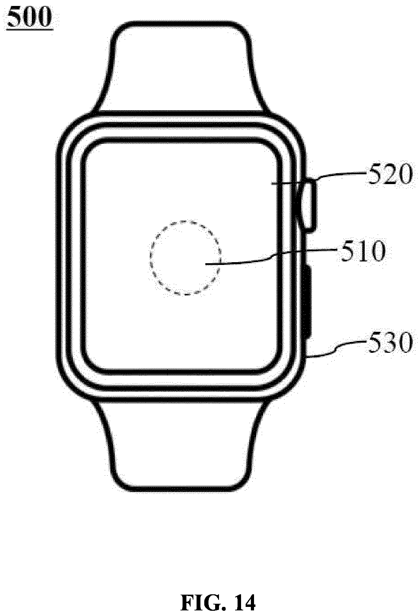

FIG. 14 is a schematic diagram illustrating another exemplary wearable device according to some embodiments of the present disclosure. Referring to FIG. 14, in some embodiments, the wearable device may be a smartwatch 500. In some embodiments, the smartwatch 500 may include a display 520 and a dial 530, with the display 520 embedded in the dial 530. The sensor is disposed in the smartwatch 500 in a similar manner as the sensor disposed in the cell phone or tablet 300. In some embodiments, the touch region 510 of the smartwatch 500 may be integrated into the display 520 or disposed on a side adjacent to the display 520. The user may control the smartwatch 500 by acting on the touch region 510 by tapping, long pressing, or swiping.

In some embodiments, the user may tap the touch region 510 to wake up the smartwatch 500 or put the smartwatch into a standby mode. In some embodiments, the user may long press the touch region 510 to turn the smartwatch 500 on or off, or terminate a functional process of the smartwatch 500 (e.g., music switching, App conversion, audio adjustment), etc.

In some embodiments, the touch region 510 may be disposed on a side of the dial 530 away from the display 520 to detect whether the smartwatch 500 is in a wearing state. The wearing detection is similar to the wearing detection of the acoustic output device 200. When the smartwatch 500 is in the wearing state, the sensors at the touch region 510 may respond to other processes of the smartwatch 500, such as monitoring the heart rate, etc. When the smartwatch 500 is not in the wearing state, the sensors may respond to other processing processes of the smartwatch 500, such as ending a non-essential process, etc.

In some embodiments, the touch region 510 may include one or more sensors. When the touch region 510 includes a plurality of sensors, the plurality of sensors may be centrally distributed within the touch region 510 of the smartwatch 500 shown in FIG. 14. In some embodiments, the plurality of sensors may be distributed in a rectangle, a triangle, or any combination thereof, and the user may slide through at least two sensors within the touch region 510 to realize different functional controls of the smartwatch 500. In some embodiments, the user may slide a corresponding pattern within the touch region 510 to compare with a preset pattern to realize the unlocking of the smartwatch 500. In some embodiments, the user may slide downward within the touch region 510 to realize a downward page turn of the smartwatch 500, and the user may also slide upward within the touch region 510 to realize an upward page turn. In some embodiments, the user may slide out an "O" shape within the touch region 510 to enable the smartwatch 500 to hang up the phone.

It should be noted that the wearable device is not limited to the acoustic output device 200, the cell phone or tablet 300, and the smartwatch 500 as described above. In some embodiments, the wearable device may include other electronic devices, such as a virtual reality device, an augmented reality device, a smart helmet, smart glasses, or the like.

It is also noted that in some embodiments, the sensors provided by embodiments of the present disclosure may be applied to electronic devices other than wearable devices, such as home appliances (e.g., televisions, refrigerators, air conditioners, control switches, smart door locks, etc.).

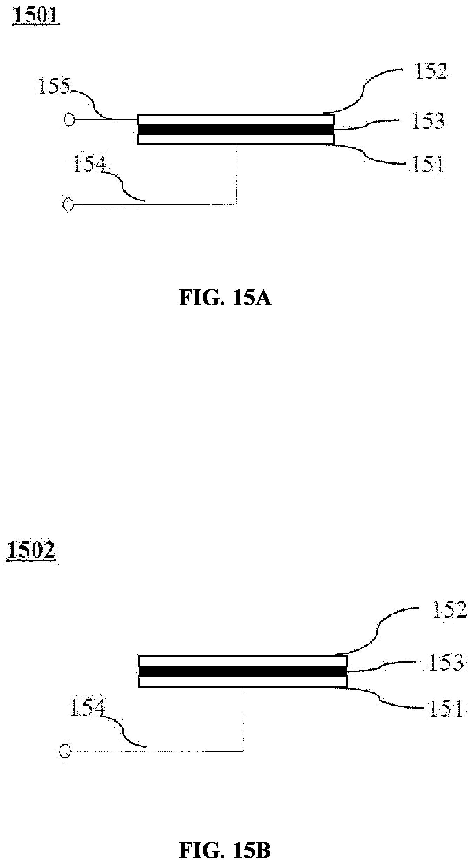

It should be noted that the capacitive sensing element in the embodiments of the present disclosure (e.g., the capacitive sensing elements shown in FIGs. 1-3, FIGs. 5, and 6) may also include at least one detecting end, which may be electrically connected with the circuits of the sensor. In some embodiments, the detecting end may be a structure made of a conductive material (e.g., made of copper, aluminum, silver, carbon, etc.). The following is illustrated in conjunction with FIG. 15A and FIG. 15B. In some embodiments, as shown in FIG. 15A, the capacitive sensing element 1501 may include a first electrode 151 and a second electrode 152 provided side by side, and a dielectric 153 provided between the first electrode 151 and the second electrode 152. In some embodiments, the capacitive sensing element may include two detecting ends, and the two detecting ends are electrically connected with two electrodes of the capacitive sensing element, respectively. When the capacitive sensing element 1501 is applied to the sensor, the human body may be approximately equivalent to a capacitor when the human body acts on the capacitive sensing element, the human body capacitance is connected in parallel to the measurement circuit of the sensor. For example, the two detecting ends may include a first detecting end 154 and a second detecting end 155. One end of the first detecting end 154 is electrically connected to the first electrode 151, and the other end of the first detecting end 151 is electrically connected to the measurement circuit of the sensor. One end of the second detecting end 155 is electrically connected to the second electrode 152, and the other end of the second detecting end 155 is electrically connected to the measurement circuit of the sensor. Descriptions regarding measuring the capacitance change of the capacitive sensing element 1501 in the sensor in FIG. 15A may be referred to FIG. 9 and FIG. 10 and related descriptions thereof. The capacitive sensing element 1502 shown in FIG. 15B has substantially the same structure as the capacitive sensing element 1501 shown in FIG. 15A.

The difference is that the capacitive sensing element 1502 shown in FIG. 15B has only a first capacitance 154, one end of the first detecting end 154 is electrically connected to one electrode of the capacitive sensing element, and the other end of the first detecting end 154 is electrically connected to the measurement circuit of the sensor. When the capacitive sensing element 1502 is applied to the sensor, the human body may be approximately equivalent to a capacitor when the human body is acting on the sensor, and the human body capacitance is connected in parallel to the circuit of the sensor. It should be noted that the first detecting end 154 in the capacitive sensing element 1502 shown in FIG. 15B is not limited to being connected to the first electrode 151, as long as the first detecting end 154 is connected to one of the two electrodes. For example, the first detecting end 154 may be connected to the second electrode 152 only.

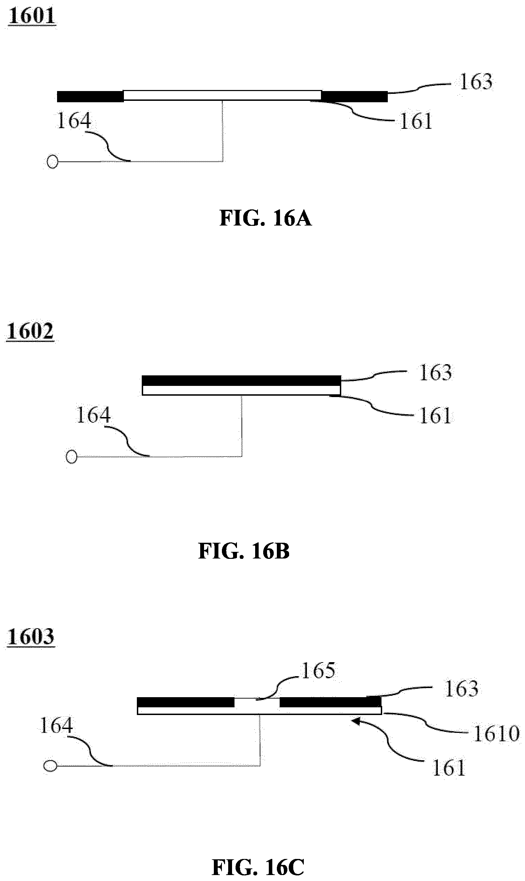

FIG. 16A-FIG. 16C are schematic diagrams illustrating exemplary sensors according to some embodiments of the present disclosure. In some embodiments, the sensor includes a sensing element, the sensing element may be applied to the housing 163, and the housing 163 is configured to carry the sensing element. In some embodiments, the sensing element may include an electrode 161 and a detecting end 164. A count of the detecting end 164 corresponds to a count of the electrode. For example, one electrode 161 corresponds to one detecting end 164, one end of the detecting end 164 is connected with the electrode 161, and the other end of the detecting end 164 is connected with the circuit of the sensor. In some embodiments, the electrode 161 connects the impedance of the body of the user into the sensor when the user is in contact with the electrode 161 or a region of the housing corresponding to the electrode 161. For example, the following will be specifically described in conjunction with the sensor shown in FIGs. 16A-16C. As shown in FIG. 16A, in some embodiments, the electrode 161 of the sensor 1601 may be embedded in a sidewall of the housing 163, and a portion or all of one side of the electrode 161 may be exposed to the external environment of the housing 163. A portion or all of one side of the electrode 161 is exposed to the outer surface of the housing 163 such that when the user is in contact with the electrode 161, the human body impedance of the body of the user is connected in series into the circuit of the sensor. In some embodiments, the electrode 161 may also be disposed inside or on the inner sidewall of the housing 163. For example, the electrode 161 may be attached to the inner sidewall of the housing 163. As another example, the electrode 161 may be fixed in the interior chamber of the housing 163 by a fixing structure (e.g., a bracket). As the sensor 1602 shown in FIG. 16B, in some embodiments, one side of the electrode 161 is attached to the inner sidewall in the housing 163, or at least a portion of the electrode 161 is embedded in the inner sidewall of the housing 163, where the connection manner includes, but is not limited to, any one or more of bonding, welding, embedding, or the like. In some embodiments, the region of the housing 163 corresponding to the electrode 161 may be made of a conductive material (e.g., conductive silicone, copper, aluminum, silver, carbon, etc.) so that human impedance may be connected into the circuit of the sensor when the user contacts the region. In some embodiments, when the electrode 161 is provided in the interior chamber of the housing 163, the electrode 161 may be electrically connected with a conductive region of the housing 163 (e.g., the region of the housing 163 corresponding to the electrode 161 described above) via a wire. As the sensor 1603 shown in FIG. 16C, in some embodiments, the electrode 161 may include an electrode body 1610 and a conductive structure 165, one end of the conductive structure 165 is electrically connected with the electrode body 1610, the other end of the conductive structure 165 may extend out of an inner surface of the housing 163, and the other end of the conductive structure 165 is concave downwardly with respect to the outer surface of the housing 163. When there are a plurality of conductive structures 165, two adjacent conductive structures 165 are separated by a housing region between the two. Since the volume of the droplet is small, when the droplet accumulates on the outer surface of the housing 163, as the conductive structure 165 is concave downwardly with respect to the outer surface of the housing 163, the droplet accumulates at a single conductive structure 165, thereby preventing the droplet from connecting the two adjacent conductive structures 165. In some embodiments, the other end of the conductive structure 165 may extend out of the outer surface of the housing 163, such that a portion of the conductive structure 165 may be exposed to the external environment of the housing 163 for user contact. In some embodiments, the other end of the conductive structure 165 may extend out of the housing 163 until it protrudes from the outer surface. When the end of the conductive structure 165 protrudes relative to the outer surface of the housing 163, the user may quickly determine the distribution position of the conductive structure 165 based on the sense of touch, so as to perform the relevant operation. In some embodiments, the conductive structure 165 may be an element made of a material having an electrically conductive capability. In some embodiments, the material of the conductive structure 165 may include, but is not limited to, any one or more of silver, copper, gold, aluminum, nickel, alloy, carbon, or the like. In some embodiments, the conductive structure 165 may be made of a transparent conductive material, such as an indium tin oxide film, etc. In some embodiments, the conductive structure 165 may be an element disposed independently with respect to the electrode body 1610. For example, one end of the conductive structure 165 is electrically connected with the electrode body 1610. In some embodiments, the material of the conductive structure 165 may be the same as or different from the material of the electrode body 1610. In some embodiments, the conductive structure 165 may be a portion of the electrode body 1610. For example, the conductive structure 165 and the electrode body 1610 are an integrated structure, and the conductive structure 165 is a protruding structure on one side of the electrode body 1610. In other words, a portion of the electrode body 1610 may be exposed to the external environment of the housing 163.

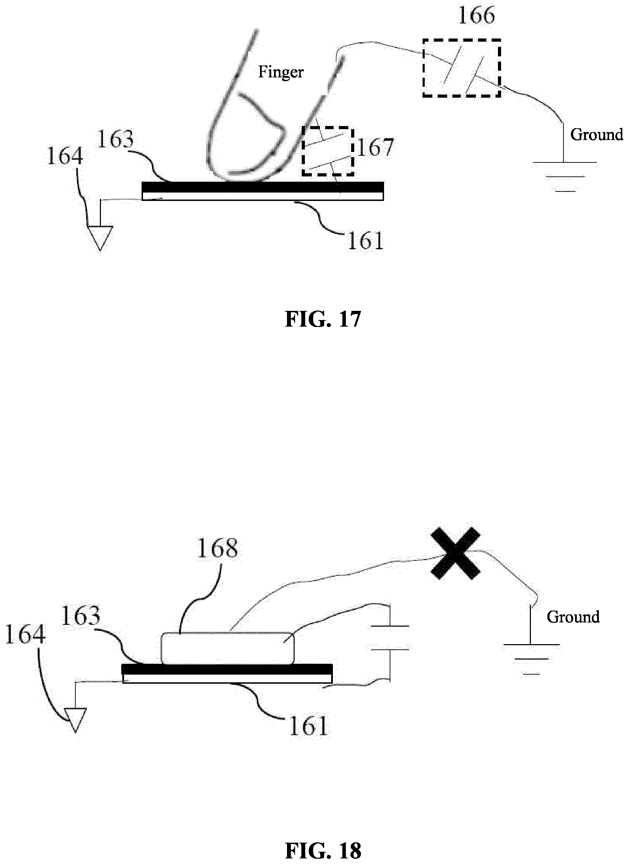

The sensors shown in the FIGs. 16A- FIG. 16C may effectively distinguish between the human touch and the case where the droplets act on the sensor, which will be described in detail in connection with FIG. 17 and FIG. 18 below. FIG. 17 is a schematic diagram illustrating the body of a user in contact with a sensor according to some embodiments of the present disclosure. FIG. 18 is a schematic diagram illustrating a droplet acting on a sensor according to some embodiments of the present disclosure. As shown in FIG. 17, when a finger touches the touch region of the sensor shown in FIG. 16A-FIG. 16C (e.g., the electrode 161 shown in FIG. 16A, the housing 163 with the conductive capability shown in FIG. 16B, or the conductive structure 165 shown in FIG. 16C), since the finger and the human body may be considered to be a conductor, and the capacitance166 between the human body and the ground and the capacitance167 between the device ground corresponding to the sensor and the ground are sufficiently large to have only a very small capacitive resistance to the high-frequency alternating current excitation signal, the potential of the finger in the touching system may be considered to be approximated as the potential of the device ground. As shown in FIG. 18, when a droplet 168 (e.g., salt water) acts on the touch region of the sensor shown in FIGs. 16A-16C, since the droplet 168 is electrically conductive and may be considered a conductor, the droplet 168 may also change the electric field coupling between electrodes 161. However, the surface area of the droplet 161 is much smaller than the human body, the capacitance 166 between the human body and the ground no longer exists, and the capacitance between the droplet 161 and the ground is very small, which is approximated to zero. The potential of the droplet 161 in the touch system may not be approximated as the potential of the device ground, and the potential of the droplet 161 is determined by the potential of the electrode 161. It is thus known that when the human body contacts the touch region of the sensor provided in the embodiments of the present disclosure, the human body may form a path with the ground and the device corresponding to the sensor. However, the droplet 168 acting on the touch region of the sensor may not form a path with the device corresponding to the sensor and the earth. Therefore, by measuring the current change in the path formed by the human body, the ground, and the sensor, the human touch and droplet action can be distinguished, thereby preventing the interference of the droplet on the sensor and improving the accuracy of the sensor for human touch control.

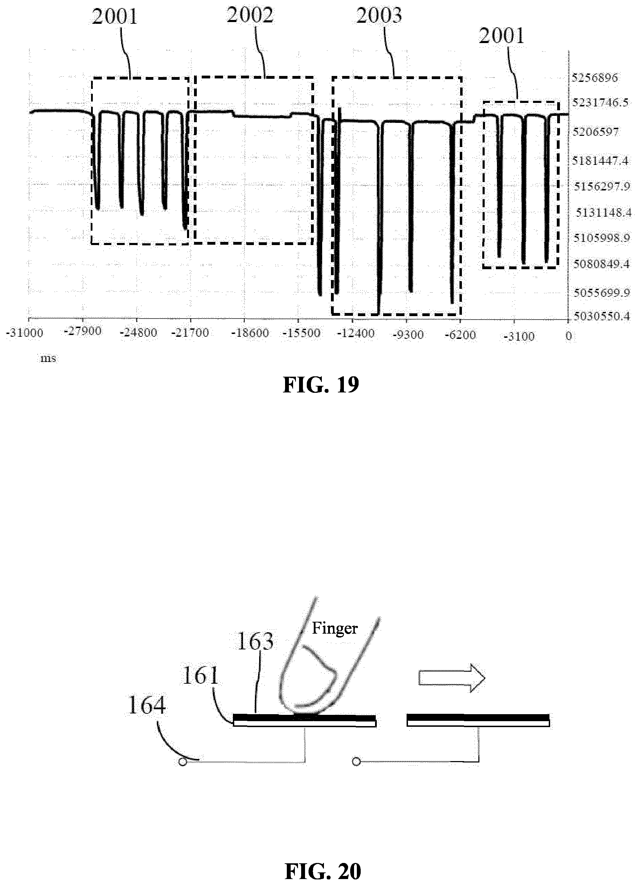

FIG. 19 is a graph illustrating a change curve of a resonant frequency when a finger and a droplet act on the electrodes of a sensor according to some embodiments of the present disclosure. As shown in FIG. 19, the horizontal coordinate denotes the time (ms), and the vertical coordinate denotes the resonant frequency (Hz). It should be noted that, according to the equation of the resonant frequency $f_0$: $f_0 = \frac{1}{2\pi\sqrt{LC}}$, the resonant frequency may be used to reflect the amount of the change in capacitance. As shown in FIG. 19, the region 2001 shows the change curve of the resonant frequency corresponding to the electrode of the sensor lightly touched by dry hands, region 2002 shows the change curve of the resonant frequency corresponding to the electrode of the sensor lightly touched by saltwater droplets, and region 2003 shows the change curve of the resonant frequency corresponding to the electrode of the sensor lightly touched by wet hands. According to region 2001, region 2002, and region 2003, the resonant frequency (i.e., the capacitance of the sensor) when the human hand acts on the electrodes of the sensor has significant changes, whereas the resonant frequency when the saltwater droplets act on the electrodes of the sensor has almost no fluctuation. Thus, the sensor provided by the embodiments of the present disclosure prevents the interference of the droplets on the sensor and improves the accuracy of the sensor for human touch control.

In some embodiments, there may be a plurality of sensing elements arranged in an array. It should be noted that the sensors shown in FIG. 20 are illustrative only, and in some other embodiments, the count of the sensing elements may be but not limited to two. For example, in some embodiments, the count of the sensing elements may also be 3, 4, 5, or more. In some embodiments, the plurality of sensing elements may be arranged in an array or a nonarray. For example, in some embodiments, the plurality of sensing elements may be arranged in a linear arrangement. In some embodiments, the plurality of sensing elements may be arranged in an array. In some embodiments, the plurality of sensing elements may be arranged in a regular shape such as a triangle, a circle, etc., an ellipse, etc., or other irregular shapes. In addition, the sensing element of the sensor is not limited to the case where the electrodes are disposed inside the housing, but may also be the electrode structure and distribution shown in FIG. 16A and FIG. 16C. In some embodiments, when the sensor includes a plurality of sensing elements, the plurality of sensing elements are spaced apart. The sensor may also include a processor, and the processor may recognize, in response to the time of the user touching different sensing elements, the gesture of the user.

When the sensor includes the plurality of sensing elements, the droplet may cover the electrodes of two adjacent sensing elements at the same time. The two adjacent electrodes are connected by the droplet, and the two adjacent electrodes and the droplet form a structure similar to a capacitive structure, thus forming an additional capacitance field. In such cases, the touch signal of the sensor when the human body touches (tapping or sliding) different electrodes may be submerged, making the sensor unable to distinguish between the human touch and the droplet action.

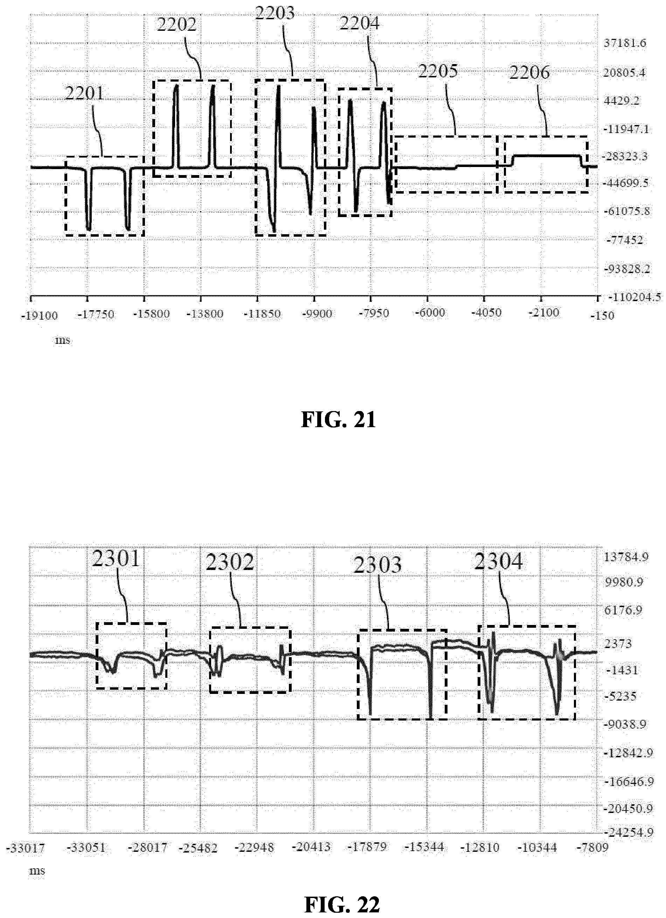

Based on the issues described above, in some embodiments, the processor may also use a signal differential processing to minimize the effect of the droplet covering two adjacent electrodes. In some embodiments, the sensor may include a first electrode and a second electrode. The signal differential processing may include obtaining a first electrical signal change value corresponding to the first electrode and a second electrical signal change value corresponding to the second electrode and determining a touch manner of the user based on difference information between the second electrical signal change value and the first electrical signal change value. In some embodiments, the difference information may include a difference magnitude and a positive or negative of the difference. In order to more clearly describe the signal differencing processing, the sensor having two electrodes (i.e., the sensor having two sensing elements) is used here as an example. The two electrodes may include a first electrode and a second electrode disposed sequentially from top to bottom along a spatial direction, the first electrical signal change value corresponding to the first electrode and the second electrical signal change value corresponding to the second electrode are obtained, and the difference between the second electrical signal change value and the first electrical signal change value is calculated. For example, when the user contacts only the first electrode, the first electrical signal change value generated by the first electrode is A1, and the second electrical signal change value corresponding to the second electrode is 0. At this time, the difference information between the second electrical signal change value and the first electrical signal change value is -A1. As another example, when the user contacts only the second electrode, the second electrical signal change value generated by the second electrode is A2, the first electrical signal change value corresponding to the first electrode is 0. At this time, the difference information between the second electrical signal change value and the first electrical signal change value is A2. As yet another example, when the user slides upwards and contacts the second electrode first and then the first electrode, the difference information between the second electrical signal change value and the first electrical signal change value changes from A2 to - A1; and when the user slides downwards and contacts the first electrode first and then the second electrode, the difference information between the second electrical signal change value and the first electrical signal change value changes from -A1 to A2. When the saltwater droplet covers both the first electrode and the second electrode, or when the saltwater droplet is located at one of the first electrode or the second electrode, the difference information remains unchanged, as shown in FIG. 21. FIG. 21 is a graph illustrating a change curve of an electrical signal in different touch manners according to some embodiments of the present disclosure. Region 2201 shows the change curve of the electrical signal corresponding to the first electrode of the sensor touched lightly by a finger, region 2202 shows the change curve of the electrical signal corresponding to the second electrode of the sensor touched lightly by a finger, region 2203 shows the change curve of the electrical signal corresponding to sliding the first electrode and the second electrode of the sensor downward with a finger, region 2204 shows the change curve of the electrical signal corresponding to sliding the second electrode and the first electrode of the sensor upward with a finger, region 2205 shows the change curve of the electrical signal corresponding to applying the saltwater droplet to one of the second electrode or the first electrode of the sensor, and region 2206 shows the change curve of the electrical signal corresponding to applying the saltwater droplet to the second electrode and the first electrode of the sensor. According to FIG. 21, with the above signal differential processing, the electric signal remains unchanged when the saltwater droplet is applied to a single electrode of the sensor, and the fluctuation of the electric signal is very small when the saltwater droplet is applied to the first electrode and the second electrode of the sensor at the same time. On the contrary, when the electrodes of the sensor are touched or slid by a finger, the electrical signal has obvious changes.

Based on the above issues, in some embodiments, in order to prevent the droplet from contacting two electrodes at the same time, a sensing element having a conductive structure as illustrated in FIG. 16C may be used, and a distance between two adjacent conductive structures 165 of the plurality of conductive structures 165 may be within a range of 0.05 mm-5 cm. For example, in some embodiments, the distance between two adjacent conductive structures in the plurality of conductive structures 165 may be within a range of 0.08 mm-3 cm. In some embodiments, the distance between two adjacent conductive structures 165 in the plurality of conductive structures 165 may be within a range of 0.1 mm-1 cm. In some embodiments, the distance between two adjacent conductive structures 165 may be the same or different. In some embodiments, the droplet may be prevented from covering a plurality (e.g., two or more) of conductive structures 165 at the same time by controlling the distance between two adjacent conductive structures 165. Merely by way of example, in some embodiments, it has been experimentally found that the diameter of the sweat or droplets deposited on the surface of the housing 163 is less than 5 mm. Based on this, in order to avoid a single droplet covering a plurality of (e.g., two or more) conductive structures 165 at the same time, the distance between two adjacent conductive structures 165 may be within a range of 8 mm-1 cm. In some embodiments, in order to prevent liquid from accumulating at the conductive structure 165, a hydrophobic coating may be applied to the end of the conductive structure 165 that extends out of the outer surface of the housing 163 and/or to the outer surface of the housing 163 to reduce the adhesion force between the liquid and the end of the conductive structure 165 that extends out of the outer surface of the housing 163 and/or the outer surface of the housing 163. When the user sweats during exercise or touches water, the liquid may slide off on the surface of the housing 163, thereby preventing the liquid from accumulating on the surface of the housing 163. In some embodiments, a protruding structure may be provided between two adjacent conductive structures 165 to form a curved surface of the housing 163 between the adjacent conductive structures 165 to prevent the liquid from accumulating at the conductive structure 165.

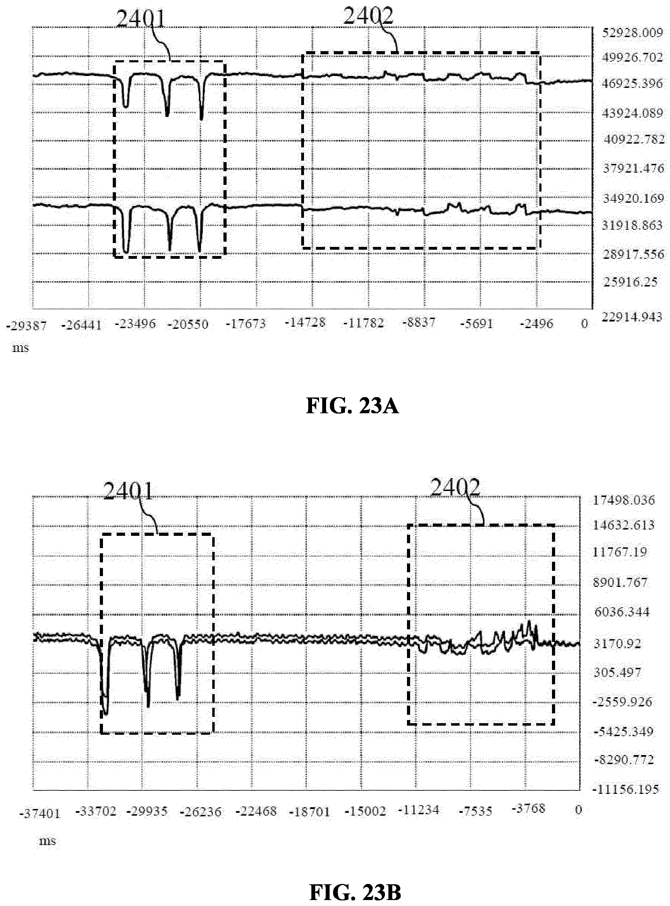

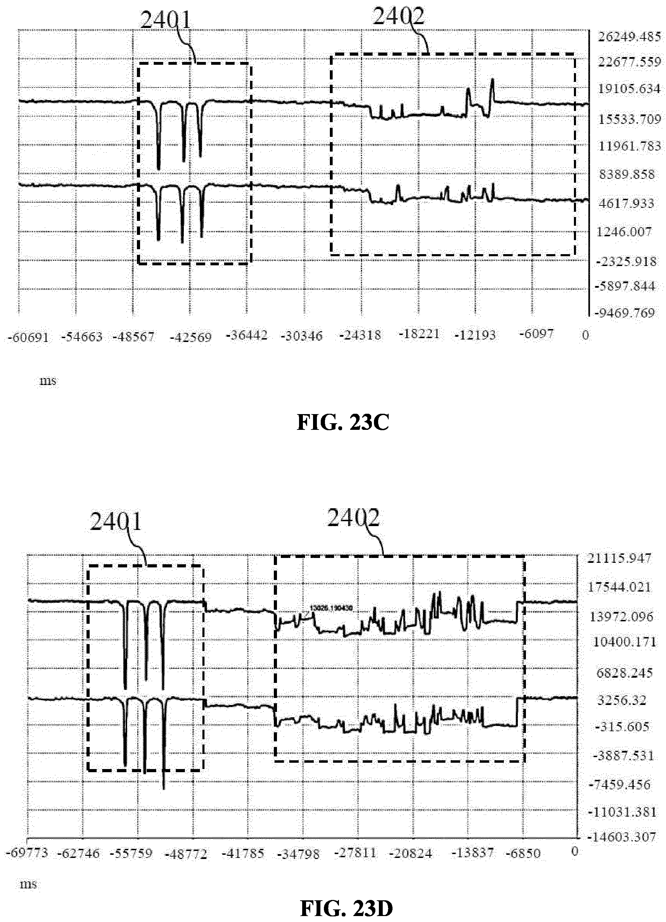

When the sensor includes a plurality of sensing elements and the sensing elements are electrodes, when the user wears the sensor during exercise, the user's wet hair or wet clothing (e.g., when the arm is lifted) may accidentally touch the sensor, which may affect the recognition of the sensor on the touch action of the user. The electrodes are large in size and form a large facing area with the liquid, which makes the signals generated by the sensing elements of the sensor when the wet hair, sweat, etc. act on the sensor very close to and difficult to distinguish from the signals generated by the sensing elements of the sensor when the finger contacts the sensor. It should be noted that the facing area in the embodiment of the present disclosure refers to the area where the liquid overlaps with the electrode. In some embodiments, the electrode may be a needle electrode, and compared with a sheet electrode, the needle electrode may reduce the coupling capacitance caused by the facing area. The capacitance of the human body is greater than the capacitance of the sweat, thus enabling the sensor to distinguish between the human touch and sweat accumulation on the sensor, ensuring the accuracy of the sensor in recognizing the user's action. FIG. 22 is a graph illustrating change curves of resonant frequencies collected when a finger and wet hair act on two needle electrodes of a sensor according to some embodiments of the present disclosure. As shown in FIG. 22, the horizontal coordinate denotes the time (ms), and the vertical coordinate denotes the resonant frequency (Hz). As shown in FIG. 22, region 2301 shows the change curve of the resonant frequency collected when wet hair is used to lightly touch the needle electrode of the sensor, region 2302 shows the change curve of the resonant frequency collected when wet hair is used to slide the needle electrode of the sensor, region 2303 shows the change curve of the resonant frequency collected when the hand is used to lightly touch the needle electrode of the sensor, and region 2304 shows the change curve of the resonant frequency collected when the hand is used to slide on the needle electrode of the sensor. According to region 2301, region 2302, region 2303, and region 2304, the resonant frequency (i.e., the amount of change in capacitance of the sensor) when the human hand acts on the needle electrode of the sensor is significantly changed, while the fluctuation of the resonant frequency when the wet hair acts on the needle electrodes of the sensor is small. Therefore, by using the needle electrode, the sensor provided by the embodiment of the present disclosure may prevent the interference of wet hair or wet clothing on the sensor and improve the accuracy of the sensor for human touch control. To further illustrate the influence of the size of the electrode on the accuracy of the sensor, the following will be illustrated in conjunction with FIG. 23A to FIG. 23D.

FIG. 23A-FIG. 23D are graphs illustrating change curves of resonant frequencies collected by sensors according to some embodiments of the present disclosure. Merely by way of example, each of the sensors in FIGs. 23A-23D includes two electrodes (e.g., a first electrode and a second electrode). The hand and the wet hair of the user slide along the two electrodes of the sensor, respectively. Region 2401 in FIGs. 23A-23D shows the change curve of the resonant frequency collected when the hand of the user acts on the electrodes of the sensor, and region 2402 in FIGs. 23A-23D shows the change curve of the resonant frequency collected when the wet hair acts on the electrodes of the sensor. The electrodes in FIG. 23A-FIG. 23D are progressively larger in size. According to FIG. 23A-FIG. 23D, as the size of the electrodes increases, the change in the resonant frequency collected when the wet hair acts on the electrodes in the sensor becomes more significant. Thus, in order to increase the difference between the effect of the liquid or wet hair on the sensor and the effect of the human hand on the sensor, thus reduce the interference of the wet hair or wet clothing on the sensor in recognizing the touch of the user's hand, the size of the electrode should not be too large. The size of the electrode here refers to the area of the electrode exposed to the external environment.

In order to make the electrodes of the sensor form a small facing area with the liquid, increase the difference between the effect of the liquid or the wet hair on the sensor and the effect of the human hand on the sensor, and reduce the interference of the wet hair or the wet clothing on the sensor in recognizing the touch of the user's hand, in some embodiments, the electrodes of the sensor may be needle electrodes to reduce the coupling capacitance caused by the facing area. In addition, the capacitance of the human body is greater than the capacitance of the sweat, so that the sensor may distinguish between the human touch and the sweat accumulation on the sensor, which ensures the accuracy of the sensor in recognizing the user's action. In some embodiments, the size of the needle electrode along a long axis direction is within a range of 5 mm-50 mm, and the size of the needle electrode along a short axis direction is within a range of 0.1 mm-5 mm. In such cases, the electrodes of the sensor and the liquid form a relatively small facing area, thus increasing the difference between the effect of the liquid or wet hair on the sensor and the effect of the human hand acting on the sensor. In some embodiments, the size of the needle electrode along the long axis direction is within a range of 10mm-15mm, and the size of the needle electrode along the short axis direction is within a range of 0.5mm-2mm. By controlling the size of the needle electrode to be very small, the facing area between the electrode and the liquid is further reduced, thereby increasing the difference between the effect of the liquid or wet hair on the sensor and the effect of the human hand on the sensor. In some embodiments, to reduce the facing area between the electrodes of the sensor and the liquid, a ratio of the size of the needle electrode along the long axis direction to the size of the needle electrode along the short axis direction may be greater than 2. In some embodiments, the ratio of the size of the needle electrode along the long axis direction to the size of the needle electrode along the short axis direction may be greater than 5 to further reduce the facing area between the electrodes of the sensor and the liquid.

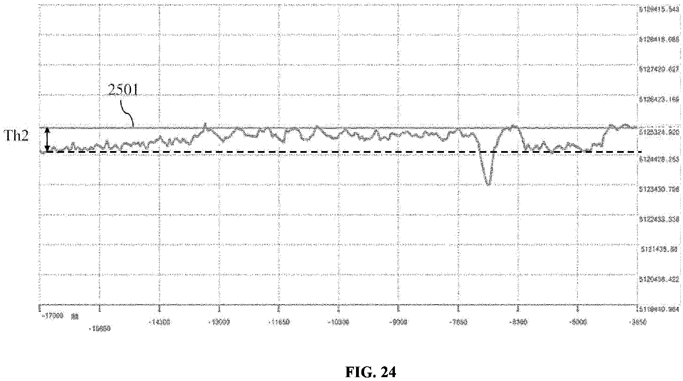

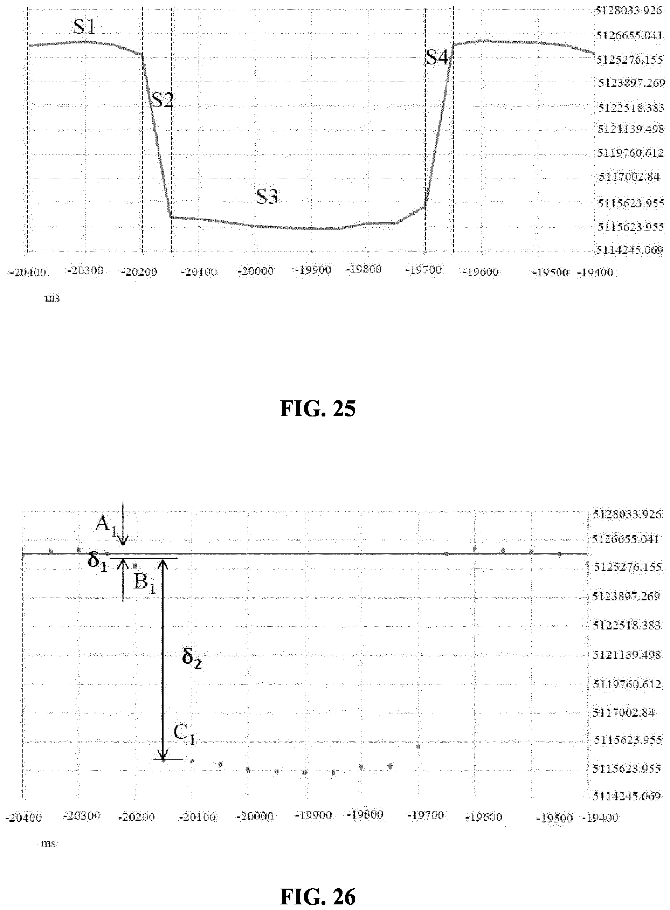

FIG. 24 is a diagram illustrating a signal of a sensor according to some embodiments of the present disclosure. As shown in FIG. 24, the signal graph read by the measurement circuit of the sensor is not a straight line when the signal is read due to noise fluctuation, zero drift, environmental interference, etc. If a specific judgment threshold Th2 is used to analyze the fluctuation of the resonant frequency to determine whether the user acts on the sensor, there may be a problem of misjudgment and wrong judgment. A zero-following algorithm is adopted in some embodiments of the present disclosure to eliminate disturbances caused by noise fluctuation, zero drift, environmental disturbances, etc. In some embodiments, the processor of the sensor is configured to adjust the zero point based on fluctuation information of the resonant frequency. In conjunction with FIG. 25 and FIG. 26, the S1 segment in FIG. 25 is the resonant frequency collected when the user doesn't act on the sensor, wherein the resonant frequency only has small amplitude noise, slow drift. When an electrical reference value is changed, the zero point changes with the resonant frequency. For example, the zero point increases as the resonant frequency increases and decreases as the resonant frequency decreases, and the resonant frequency fluctuates over a small range. Specifically, three adjacent data points $A_1$, $B_1$, and $C_1$ may be selected in the resonant frequency, and the data changes of two adjacent data points $\delta_1$ and $\delta_2$ may be obtained by calculating a difference between the two adjacent data points, respectively. When $\delta_1$ and $\delta_2$ are both less than a fluctuation threshold Th1, and the differences between the data points $A_1$, $B_1$, and $C_1$ and the zero point corresponding to the end of the S1 segment (which is also referred to as a zero point value before a breakthrough of the resonant frequency) are all less than the fluctuation threshold Th1, it indicates that the user doesn't act on the sensor.

In some embodiments, the processor of the sensor is further configured to remain the zero point until falling change information of the electrical signal reaches a minimum value of the electrical signal. Continuing to refer to the segment S2 of the resonant frequency curve in FIG. 25, as the body (e.g., the finger) of the user approaches the electrode of the sensor, the impedance of the body of the user begins to be connected to the measurement circuit of the sensor. The resonant frequency read by the sensor suddenly decreases due to the high impedance of the body of the user. Continuing to refer to segment S3 of the resonant frequency curve in FIG. 25, when the body (e.g., the finger) of the user remains in contact with the electrode of the sensor, the resonant frequency read by the sensor reaches the minimum value. In the process of the body of the user approaching the sensor until it remains in contact with the sensor, the change in the resonant frequency read by the measurement circuit of the sensor is primarily caused by the connection of the impedance of the body of the user, the zero point is kept constant. In some embodiments, the falling change information of the resonant frequency includes the data change of two adjacent data points. For example, in segment S2, the difference $\delta_1$ between data points $A_1$ and $B_1$ is less than the fluctuation threshold Th1, and the difference $\delta_2$ between data points $B_1$ and $C_1$ is greater than the fluctuation threshold Th1. As another example, in the segment S3, the difference $\delta_1$ between data points $A_1$ and $B_1$ and the difference $\delta_2$ between data points $B_1$ and $C_1$ are both less than the fluctuation threshold Th1, and the differences between the zero point corresponding to the end of the segment S1 (also referred to as the zero values before the breakthrough of the resonant frequency), and data points $A_1$, $B_1$, and $C_1$ are all greater than a determination threshold Th2.

In some embodiments, the processor of the sensor is further configured to rise the zero point with the resonant frequency based on rising change information of the resonant frequency. Continuing to refer to the segment S2 of the resonant frequency curve in FIG. 25, when the body (e.g., the finger) of the user moves away from the electrodes of the sensor, the impedance of the body of the user is no longer connected into the measurement circuit of the sensor. At this time, the resonant frequency read by the sensor suddenly rises, and the zero point increases with the resonant frequency until the resonant frequency returns to segment S1. In some embodiments, the falling change information of the resonant frequency includes the data change of two adjacent data points. For example, in segment S3, the difference $\delta_1$ between data points $A_1$ and $B_1$ is less than the fluctuation threshold Th1, the difference $\delta_2$ between data points $B_1$ and $C_1$ is greater than the fluctuation threshold Th1.

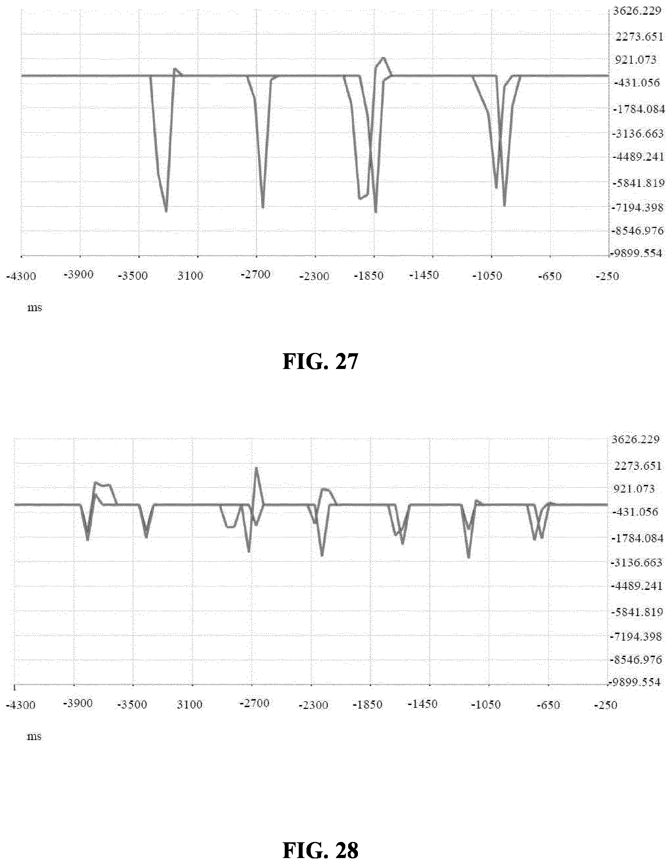

FIG. 24-FIG.26 are implementations in which a single electrode is provided in the sensor to recognize the user's tapping control operation. In some embodiments, a plurality of electrodes may be included in the sensor, and a processor of the sensor may recognize a gesture of the user in response to the time points when the user touches the different electrodes. Merely by way of example, the plurality of electrodes may be distributed in a straight line, and the user slides along an extension direction of the straight line. When the user's finger slides, the time points at which it acts on different electrodes are different, and the time points at which the resonance frequencies corresponding to the different electrodes are collected are different. The processor may determine the gesture of the user (e.g., the sliding direction) based on the time point at which the resonant frequency of the sensor corresponding to different electrodes changes. FIG. 27 is a graph illustrating change curves of resonant frequencies when the hand of a user acts on two electrodes in a sensor according to some embodiments of the present disclosure. FIG. 28 is a graph illustrating change curves of resonant frequencies when wet hair acts on two electrodes in a sensor according to some embodiments of the present disclosure. According to FIG. 27 and FIG. 28, under the premise of adopting the zero-following algorithm, the change amount of the resonant frequency when the hand of the user acts on the sensor is significantly larger than the change amount of the resonant frequency when the wet hair acts on the sensor. Thus, by adopting the zero-following algorithm to obtain the change amount of the resonant frequency of the sensor, the difference between the change amount of the resonant frequency of the electrical signal generated when the hand of the user acts on the sensor and the change amount of the resonant frequency generated when the wet hair acts on the sensor may be further improved, thereby improving the accuracy of the sensor.

It should be noted that the sensors shown in FIG. 16A-FIG. 28 may be applied to at least one of a headphone, a smart bracelet, a smart ring, smart glasses, a smart helmet, a virtual reality device, or an augmented reality device, for example, the electronic device shown in FIGs. 11-14.

It should be noted that beneficial effects that may be produced by different embodiments are different, and the beneficial effects that may be produced in different embodiments may be any one or a combination of any of the foregoing, or any other beneficial effect that may be obtained.

Having thus described the basic concepts, it may be rather apparent to those skilled in the art after reading this detailed disclosure that the foregoing detailed disclosure is intended to be presented by way of example only and is not limiting. Although not explicitly stated here, those skilled in the art may make various modifications, improvements, and amendments to the present disclosure. These alterations, improvements, and amendments are intended to be suggested by this disclosure and are within the spirit and scope of the exemplary embodiments of the present disclosure.

**Claims**

1. A sensor, comprising:

   a sensing element and a conductive structure, wherein the sensor is applied to a housing; and the housing is configured to carry the sensing element and the conductive structure, the sensing element is disposed inside or on an inner sidewall of the housing, at least a portion of the conductive structure is exposed to an external environment of the housing, and the conductive structure is electrically connected with the sensing element.

2. The sensor of claim 1, wherein the sensor includes a plurality of sensing elements, the plurality of sensing elements are arranged in an array, and each of the plurality of sensing elements has a corresponding conductive structure in a plurality of conductive structures.

3. The sensor of claim 2, wherein the plurality of conductive structures corresponding to the plurality of sensing elements are arranged at intervals.

4. The sensor of claim 3, wherein a distance between two adjacent conductive structures among the plurality of conductive structures is within a range of 0.05 mm-5 cm.

5. The sensor of any one of claims 1-4, wherein the conductive structure is concave downwardly with respect to an outer surface of the housing.

6. The sensor of any one of claims 1-5, wherein the housing includes an aperture portion corresponding to the conductive structure, the conductive structure is in flow communication with the external environment of the housing through the aperture portion, and the conductive structure is in an interference fit with the aperture portion.

7. The sensor of any one of claims 1-6, wherein the sensing element includes a capacitive sensing element, the capacitive sensing element is disposed inside or on the inner sidewall of the housing, and an electrode of the capacitive sensing element is electrically connected with the conductive structure.

8. The sensor of claim 7, wherein

   the electrode includes a first electrode and a second electrode, the first electrode and the second electrode are disposed inside the housing,
   the first electrode has a first side, a side of the second electrode is arranged side by side along an extension direction of the first side, and one end portion of the first electrode is spaced apart from one end portion of the second electrode, and
   the conductive structure is electrically connected with one of the first electrode or the second electrode.

9. The sensor of claim 8, wherein a distance between the first electrode and the second electrode is within a range of 8 mm-10 mm.

10. The sensor of any one of claims 7-9, further comprising a measurement circuit, wherein the measurement circuit is electrically connected with the capacitive sensing element and configured to obtain a capacitance change value of the capacitive sensing element.

11. The sensor of any one of claims 1-6, wherein

the sensing element includes an inductive sensing element disposed inside the housing and includes an inductive element, a capacitive element, and a processing chip, the inductive element is connected in parallel with the capacitive element to form a loop, the processing chip is configured to obtain a resonant frequency of the loop, and the inductive element is electrically connected with the conductive structure.

12. A wearable device, comprising:
a sensor including:

a sensing element;
a conductive structure, one end of the conductive structure being electrically connected with the sensing element; and
a wearable device body, including at least a carrier structure configured to carry the sensing element and the conductive structure, wherein the sensing element is disposed inside or on an inner sidewall of the carrier structure, at least a portion of the conductive structure is exposed to an external environment of the carrier structure, and the conductive structure is electrically connected with the sensing element.

13. The wearable device of claim 12, wherein the conductive structure is disposed at a position on the carrier structure that is in contact with a user, and the sensing element is configured to detect a wearing state of the wearable device.

14. The wearable device of claim 12, wherein the conductive structure is disposed at a position on the carrier structure that is not in contact with the user, and the sensor controls, in response to a touch gesture of the user, a work process of the wearable device.

15. The wearable device of any one of claims 12-14, wherein the sensor includes a plurality of sensing elements, the plurality of sensing elements are arranged in an array, and each of the plurality of sensing elements has a corresponding conductive structure in a plurality of conductive structures.

16. The wearable device of claim 15, wherein the plurality of conductive structures corresponding to the plurality of sensing elements are arranged at intervals.

17. The wearable device of claim 16, wherein a distance between two adjacent conductive structures among the plurality of conductive structures is within a range of 0.05 mm-5 cm.

18. The wearable device of any one of claims 12-17, wherein the conductive structure is concave downwardly with respect to an outer surface of the carrier structure.

19. The wearable device of any one of claims 12-18, wherein the carrier structure includes an aperture portion corresponding to the conductive structure, the conductive structure is in flow communication with the external environment of the carrier structure through the aperture portion, and the conductive structure is in an interference fit with the aperture portion.

20. The wearable device of any one of claims 12-18, wherein the sensing element includes a capacitive sensing element, the capacitive sensing element is disposed inside the carrier structure, and an electrode of the capacitive sensing element is electrically connected with an end of the conductive structure away from an outer surface of the carrier structure.

21. The wearable device of claim 20, wherein

the electrode includes a first electrode and a second electrode, the first electrode and the second electrode are disposed inside the carrier structure,
the first electrode has a first side, a side of the second electrode is arranged side by side along an extension direction of the first side, and one end portion of the first electrode is spaced apart from one end portion of the second electrode, and
the conductive structure is electrically connected with one of the first electrode or the second electrode.

22. The wearable device of claim 21, wherein a distance between the first electrode and the second electrode is within a range of 8 mm-10 mm.

23. The wearable device of any one of claims 20-22, further comprising a measurement circuit, wherein the measurement circuit is electrically connected with the capacitive sensing element and configured to obtain a capacitance change value of the capacitive sensing element.

24. The wearable device of any one of claims 11-17, wherein

the sensor includes a first inductive sensing element disposed inside the carrier structure, the first inductive sensing element includes an inductive element, a capacitive element, and a processing chip,

the inductive element is connected in parallel with the capacitive element to form a loop, the processing chip is configured to obtain a resonant frequency of the loop, and the inductive element is electrically connected with the conductive structure.

25. The wearable device of any one of claims 12-24, comprising at least one of a headphone, a smart bracelet, a smart ring, smart glasses, a smart helmet, a virtual reality device, or an augmented reality device.

26. The wearable device of any one of claims 12-24, wherein the wearable device is an acoustic output device, the wearable device body includes an acoustic output unit, the acoustic output device further includes an ear hook configured to suspend the acoustic output unit at a position near the ear of the user.

27. The wearable device of claim 26, wherein

the acoustic output unit further includes a rear hook, the ear hook includes a first ear hook and a second ear hook, the acoustic output unit includes a first acoustic output unit and a second acoustic output unit, the first ear hook is connected with the first acoustic output unit and the rear hook, the second ear hook is connected with the second acoustic output unit and the rear hook,

the first ear hook suspends the first acoustic output unit at a position near one ear of the user, and the second ear hook suspends the second acoustic output unit at a position near the other ear of the user, and the first ear hook is connected with the second ear hook through the rear hook.

28. The wearable device of claim 27, wherein the wearable device body further comprises a core assembly including a first core assembly and a second core assembly, the first core assembly is connected with the first ear hook and the rear hook, and the second core assembly is connected with the second ear hook and the rear hook.

29. The wearable device of claim 28, further comprising a second inductive sensing element disposed on the ear hook or the rear hook, and the second inductive sensing element determines, based on a deformation of the ear hook or the rear hook, a deformation amount of the ear hook or rear hook.

30. A sensor, comprising:

a capacitive sensing element, wherein the capacitive sensing element is applied to a housing and disposed inside the housing,

the capacitive sensing element includes a first electrode and a second electrode, the first electrode is directly or indirectly connected with an inner surface of the housing and has a first side, a side of the second electrode is disposed opposite to the first side, and there is a distance between the first electrode and the second electrode.

31. The sensor of claim 30, wherein a thickness of a sidewall of the housing in a region corresponding to the first electrode is not greater than 1 mm.

32. The sensor of claim 30, further comprising a conductive structure, wherein one end of the conductive structure is electrically connected with the first electrode, and another end of the conductive structure is exposed to an external environment of the housing.

33. The sensor of claim 30 or 32, wherein the sensor includes a plurality of capacitive sensing elements, the plurality of capacitive sensing elements are arranged in an array, and each of the plurality of capacitive sensing elements has a corresponding conductive structure in a plurality of conductive structures.

34. The sensor of claim 33, wherein the plurality of conductive structures corresponding to the plurality of capacitive sensing elements are arranged at intervals.

35. The sensor of claim 34, wherein a distance between two adjacent conductive structures among the plurality of conductive structures is within a range of 0.05 mm-5 cm.

36. The sensor of any one of claims 32-35, wherein the conductive structure is concave downwardly with respect to an outer surface of the housing.

37. The sensor of any one of claims 32-36, wherein the housing includes an aperture portion corresponding to the conductive structure, the conductive structure is in flow communication with the external environment of the housing through the aperture portion, and the conductive structure is in an interference fit with the aperture portion.

38. The sensor of claim 31, further comprising a processor, wherein the processor determines whether a user is in contact with the sensor based on a capacitance change value of the capacitive sensing element.

39. The sensor of claim 38, wherein the processor determining whether the user is in contact with the sensor based on a capacitance change value of the capacitive sensing element includes:
in response to determining that the capacitance change value is greater than a preset threshold, determining that the user is in contact with the sensor.

40. A sensor, comprising:

a sensing element, wherein the sensing element is applied to a housing, and the housing is configured to carry the sensing element; and
the sensing element includes:

one or more electrodes; and
one or more detecting ends, wherein each electrode of the one or more electrodes corresponds to one detecting end of the one or more detecting ends, one end of a detecting end is connected with its corresponding electrode, and another end of the detecting end is connected with a circuit of the sensor;
wherein when a user is in contact with an electrode or a region of the housing corresponding to the electrode, the electrode and the detecting end corresponding to the electrode connect an impedance of the body of the user into the sensor.

41. The sensor of claim 40, wherein at least a portion of the electrode is exposed to an outside environment of the housing.

42. The sensor of claim 40 or 41, wherein the electrode is affixed to an outer surface of the housing, a dimension of the electrode along a long axis direction is within a range of 5 mm-50 mm, and a dimension of the electrode along a short axis direction is within a range of 0.1 mm-5 mm.

43. The sensor of claim 42, wherein the dimension of the electrode along the long axis direction is within a range of 10 mm-15 mm, and the dimension of the electrode along the short axis direction is within a range of 0.5 mm-2 mm.

44. The sensor of claim 40 or 41, wherein the electrode is affixed to an outer surface of the housing, and a ratio of a dimension of the electrode in a long axis direction to a dimension of the electrode in a short axis direction is greater than 2.

45. The sensor of claim 41, wherein the electrode includes an electrode body and a conductive structure, the electrode body is disposed inside or on an inner surface of the housing, one end of the conductive structure is electrically connected with the electrode body, and at least a portion of the conductive structure is exposed to an external environment of the housing.

46. The sensor of claim 45, wherein the sensor includes a plurality of sensing elements, the plurality of sensing elements are arranged in an array, each of the plurality of sensing elements has a corresponding conductive structure, and each of the plurality of the sensing elements is spaced apart from the corresponding conductive structure.

47. The sensor of claim 40, wherein the one or more electrodes are disposed inside or on an inner sidewall of the housing, and a region of the housing corresponding to the one or more electrodes is made of a conductive material.

48. The sensor of any one of claims 45-47, wherein the plurality of sensing elements include a first electrode and a second electrode, and the sensor further includes a processor configured to:

obtain a first electrical signal change value corresponding to the first electrode and a second electrical signal change value corresponding to the second electrode; and
determine a touch manner of the user based on difference information between the second electrical signal change value and the first electrical signal change value.

49. The sensor of claims 45-47, further comprising a processor configured to.

adjust a zero point based on first change information of an electrical signal;
remainthe zero point until falling change information of the electrical signal reaches a minimum value of the electrical signal; and
rise the zero point with the electrical signal based on rising change information of the elec-

**EP 4 575 438 A1**

trical signal.

<u>100</u>

130

120

110

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

200

**FIG. 12**

FIG. 13

500

520

510

530

**FIG. 14**

1501

**FIG. 15A**

1502

**FIG. 15B**

1601

**FIG. 16A**

1602

**FIG. 16B**

1603

**FIG. 16C**

166

Finger

164  163

167

Ground

161

**FIG. 17**

168

164  163

X

Ground

161

**FIG. 18**

**FIG. 19**

**FIG. 20**

**FIG. 21**

**FIG. 22**

**FIG. 23A**

**FIG. 23B**

**FIG. 23C**

**FIG. 23D**

**FIG. 24**

**FIG. 25**

**FIG. 26**

**FIG. 27**

**FIG. 28**

**EP 4 575 438 A1**

## INTERNATIONAL SEARCH REPORT

| International application No. |
|---|
| **PCT/CN2023/095165** |

### A. CLASSIFICATION OF SUBJECT MATTER

G01L1/14(2006.01)i; G06F3/044(2006.01)i

According to International Patent Classification (IPC) or to both national classification and IPC

### B. FIELDS SEARCHED

Minimum documentation searched (classification system followed by classification symbols)

IPC: G01L1/-; G06F3/-; A61B5/-; H04R1/-

Documentation searched other than minimum documentation to the extent that such documents are included in the fields searched

Electronic data base consulted during the international search (name of data base and, where practicable, search terms used)

CNABS, CNTXT, WPABSC, ENTXT, CNKI: 接触, 佩戴, 贴合, 阻抗, 生物, 检测, 传感器, 金属, 导电, 电极, 极板, 暴露, 电容, 电感, 震荡, 谐振, LC, 壳, 耳挂, 零点, 零位, 壳体, 外壳, wear+, touch+, resist+, impedance, bio+, electrode, capacit+, induct+, resonance, house, zero

### C. DOCUMENTS CONSIDERED TO BE RELEVANT

| Category* | Citation of document, with indication, where appropriate, of the relevant passages | Relevant to claim No. |
|---|---|---|
| X | CN 112711355 A (SAMSUNG ELECTRONICS CO., LTD.) 27 April 2021 (2021-04-27) description, paragraphs 79-171, and figure 3 | 1-6, 11-19, 24, 25, 40-49 |
| Y | CN 112711355 A (SAMSUNG ELECTRONICS CO., LTD.) 27 April 2021 (2021-04-27) description, paragraphs 79-171, and figure 3 | 7-10, 20-23, 26-29, 32-37 |
| X | CN 110114738 A (SHENZHEN GOODIX TECHNOLOGY CO., LTD.) 09 August 2019 (2019-08-09) description, paragraphs 64-103, and figures 1-3 | 30-31, 38-39 |
| Y | CN 110114738 A (SHENZHEN GOODIX TECHNOLOGY CO., LTD.) 09 August 2019 (2019-08-09) description, paragraphs 64-103, and figures 1-3 | 7-10, 20-23, 32-37 |
| Y | CN 211702349 U (SHENZHEN VOXTECH CO., LTD.) 16 October 2020 (2020-10-16) claim 2, and figure 1 | 26-29 |
| A | CN 103813250 A (OTICON A/S) 21 May 2014 (2014-05-21) entire document | 1-49 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **10 December 2023** | **14 December 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/095165** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 110784793 A (GOERTEK INC.) 11 February 2020 (2020-02-11)<br>entire document | 1-49 |
| A | CN 114423491 A (UE LIFE SCIENCE CO., LTD.) 29 April 2022 (2022-04-29)<br>entire document | 1-49 |
| A | CN 116133583 A (SAMSUNG ELECTRONICS CO., LTD.) 16 May 2023 (2023-05-16)<br>entire document | 1-49 |
| A | US 2018020937 A1 (CHOU CHANG'AN) 25 January 2018 (2018-01-25)<br>entire document | 1-49 |
| A | US 2022206602 A1 (DAMOATECH CO., LTD.) 30 June 2022 (2022-06-30)<br>entire document | 1-49 |

Form PCT/ISA/210 (second sheet) (July 2022)

**INTERNATIONAL SEARCH REPORT**
Information on patent family members

| International application No. |
| --- |
| **PCT/CN2023/095165** |

| Patent document cited in search report | | | Publication date (day/month/year) | Patent family member(s) | | | Publication date (day/month/year) |
| --- | --- | --- | --- | --- | --- | --- | --- |
| CN | 112711355 | A | 27 April 2021 | KR | 102236099 | B1 | 05 April 2021 |
| | | | | KR | 20210049720 | A | 06 May 2021 |
| | | | | US | 2021124453 | A1 | 29 April 2021 |
| | | | | US | 11372495 | B2 | 28 June 2022 |
| CN | 110114738 | A | 09 August 2019 | WO | 2020191594 | A1 | 01 October 2020 |
| | | | | US | 2020314527 | A1 | 01 October 2020 |
| | | | | US | 11438685 | B2 | 06 September 2022 |
| CN | 211702349 | U | 16 October 2020 | None | | | |
| CN | 103813250 | A | 21 May 2014 | EP | 2731356 | A1 | 14 May 2014 |
| | | | | EP | 2731356 | B1 | 03 February 2016 |
| | | | | US | 2014126759 | A1 | 08 May 2014 |
| | | | | US | 9219965 | B2 | 22 December 2015 |
| | | | | DK | 2731356 | T3 | 09 May 2016 |
| CN | 110784793 | A | 11 February 2020 | None | | | |
| CN | 114423491 | A | 29 April 2022 | MX | 2022000659 | A | 18 May 2022 |
| | | | | AU | 2020314838 | A1 | 03 March 2022 |
| | | | | KR | 20220050892 | A | 25 April 2022 |
| | | | | JP | 2022541901 | A | 28 September 2022 |
| | | | | BR | 112022000742 | A2 | 15 March 2022 |
| | | | | EP | 3999167 | A1 | 25 May 2022 |
| | | | | CA | 3147421 | A1 | 21 January 2021 |
| | | | | WO | 2021011757 | A1 | 21 January 2021 |
| | | | | US | 2022287567 | A1 | 15 September 2022 |
| CN | 116133583 | A | 16 May 2023 | EP | 4166075 | A1 | 19 April 2023 |
| | | | | US | 2023144358 | A1 | 11 May 2023 |
| | | | | WO | 2022015081 | A1 | 20 January 2022 |
| US | 2018020937 | A1 | 25 January 2018 | JP | 3217016 | U | 12 July 2018 |
| | | | | US | 2020085331 | A1 | 19 March 2020 |
| | | | | EP | 3278724 | A1 | 07 February 2018 |
| US | 2022206602 | A1 | 30 June 2022 | KR | 20220097137 | A | 07 July 2022 |
| | | | | US | 11507230 | B2 | 22 November 2022 |
| | | | | KR | 102364056 | B1 | 18 February 2022 |

Form PCT/ISA/210 (patent family annex) (July 2022)